# EUROPEAN PATENT SPECIFICATION

(11) **EP 4 477 690 B1**
(45) Date of publication and mention of the grant of the patent: **13.08.2025**
(21) Application number: 23179807.5
(22) Date of filing: 16.06.2023
(51) Int. Cl.: C08J 5/18, H10F 19/80

(54) **ENCAPSULANT FILM BASED ON FUNCTIONALIZED POLYOLEFINS**
VERKAPSELUNGSFOLIE AUF BASIS VON FUNKTIONALISIERTEN POLYOLEFINEN
FILM ENCAPSULANT À BASE DE POLYOLÉFINES FONCTIONNALISÉES

(43) Date of publication of application: 18.12.2024
(73) Proprietor: SABIC Global Technologies B.V., 4612 PX Bergen op Zoom (NL)
(72) Inventor: DUCHATEAU, Robbert, 6160 GA Geleen (NL); JASINSKA-WALC, Lidia, 6160 GA Geleen (NL); KRUSZYNSKI, Jakub, 6160 GA Geleen (NL); NOWICKA, Weronika, 6160 GA GELEEN (NL); SZOT, Wojciech, 6160 GA GELEEN (NL); BOUYAHYI, Miloud, 6160 GA Geleen (NL)
(74) Representative: Sabic Intellectual Property Group

(56) References cited:
- WO-A1-2022/106689
- US-A1- 2009 120 489
- US-A1- 2014 000 681

## Description

### FIELD OF INVENTION

The invention relates to a film comprising a polar group functionalized polyolefin and to the use of the film as an encapsulant film for a photovoltaic module. The invention further relates to an encapsulated solar cell comprising one or more encapsulant layers comprising the film. The invention further relates to a photovoltaic module comprising the encapsulated solar cell and to a process for making the making such a photovoltaic module.

### BACKGROUND

Polymeric materials such as ethylene-vinyl acetate copolymers (EVA) and polyolefin elastomers (POE), are commonly used as encapsulants in photovoltaic modules. Some desirable properties and functions of such polymeric materials include (i) high electrical resistance (or volume resistivity) (ii) excellent moisture and gas barrier property, (iii) ease of processing, (iv) excellent optical transmittance, and (v) suitable mechanical properties such as tensile modulus.

Polymeric material such as ethylene-vinyl acetate copolymers (EVA) and polyolefins such as polyolefin elastomers (POE) have been used for preparing polymeric encapsulants suitable for photovoltaic modules and other allied applications. However, EVA copolymer, owing to its polarity, suffer from having low volume resistivity and low moisture barrier properties, as compared to a conventional polyolefin elastomers. Further, it has been observed that EVA based films progressively darken on prolonged exposure to sunlight due to chemical degradation, which adversely affects the utility of the film. In addition, EVA resins tend to degrade on account of prolonged exposure to atmospheric moisture induced through hydrolysis. Additionally, hydrolysis of EVA forms acetic acid as an undesired side product, which is harmful for the electronic components of a photovoltaic module.

To circumvent these shortcomings of EVA copolymers, polyolefins have been investigated as a possible alternative. Despite the benefits that a polyolefin encapsulant film may offer, for example of having high volume resistivity, low gas and moisture permeability, polyolefins have their own set of shortcomings. US 2009/120489 A1 discloses an encapsulating material for solar cell comprising an ethylene-unsaturated carboxylic acid copolymer.

Therefore, it is an object of the present invention to provide a film, which can be used as an encapsulant film in a photovoltaic module having one or more of the following advantages of (i) desirably high electrical resistance (or volume resistivity), (ii) excellent adhesion property (iii) excellent moisture and gas barrier property, (iv) ease of processability, (v) excellent optical transmittance, (vi) recyclability and (vii) suitable mechanical properties such as tensile modulus.

### DESCRIPTION

Accordingly, one or more objectives of the present invention is achieved by a film comprising a blend of non-functionalized polyolefin and functionalized polyolefin,
wherein the non-functionalized polyolefin is a polymer selected from the group consisting of polyolefin thermoplast, polyolefin plastomer and polyolefin elastomer, and wherein the functionalized polyolefin is a polymer selected from the group consisting of:
a. a propylene copolymer, comprising
   i. ≥ 95.0 mol% and ≤ 99.95 mol%, preferably ≥ 98.0 mol% and ≤ 99.95 mol%, preferably ≥ 99.0 mol% and ≤ 99.9 mol%, preferably ≥ 99.5 mol% and ≤ 99.9 mol%, of polymeric units derived from propylene, and
   ii. ≥ 0.05 mol% and ≤ 5.0 mol%, preferably ≥ 0.05 mol% and ≤ 2.0 mol%, preferably ≥ 0.1 mol% and ≤ 1.0 mol%, preferably ≥ 0.1 mol% and ≤ 0.5 mol%, of polymeric units derived from a functionalized olefin monomer,
   based on the total moles of all polymeric units constituting the propylene copolymer,
**b.** a propylene terpolymer, comprising
   i. ≥ 80.0 mol% and ≤ 98.95 mol%, preferably ≥ 88.0 mol% and ≤ 98.0 mol%, preferably ≥ 90.0 mol% and ≤ 96.0 mol%, of polymeric units derived from propylene;
   ii. ≥ 0.1 mol% and ≤ 19.95 mol%, preferably ≥ 1.0 mol% and ≤ 10.0 mol%, preferably ≥ 3.5 mol% and ≤ 9.9 mol%, of polymeric units derived from a first olefin monomer comprising either 2, or 4 to 8 carbon atoms, preferably the first olefin monomer comprises 2 or 6 carbon atoms; and
   iii. ≥ 0.05 mol% and ≤ 5.0 mol%, preferably ≥ 0.1 mol% and ≤ 2.0 mol%, preferably ≥ 0.1 mol% and ≤ 0.5 mol%, of polymeric units derived from a functionalized olefin monomer,
   based on the total moles of all polymeric units constituting the propylene terpolymer;
**c.** an ethylene terpolymer, comprising:
   i. ≥ 80.0 mol% and ≤ 98.95 mol%, preferably ≥ 90.0 mol% and ≤ 97.0 mol%, of polymeric units derived from ethylene,
   ii. ≥ 0.1 mol% and ≤ 19.95 mol%, preferably ≥ 2.5 mol% and ≤ 9.9 mol%, of polymeric units derived from a second olefin monomer comprising 3 to 8 carbon atoms, preferably the second olefin monomer comprises 8 carbon atoms; and
   iii. ≥ 0.05 mol% and ≤ 5.0 mol%, preferably ≥ 0.1 mol% and ≤ 0.5 mol%, of polymeric units derived from a functionalized olefin monomer;
   based on the total moles of all polymeric units constituting the ethylene terpolymer; and
**d.** a polymer mixture comprising any combination of polymers (a) to (c);
   wherein the functionalized olefin monomer is a monomer selected from:
   i. a hydroxyl group containing olefin monomer having 4 to 12 carbon atoms, preferably 4 to 8 carbon atoms;
   ii. a carboxylic acid containing olefin monomer having 2 to 12 carbon atoms, preferably 4 to 8 carbon atoms; and
   iii. an esterified olefin monomer represented by formula (1): 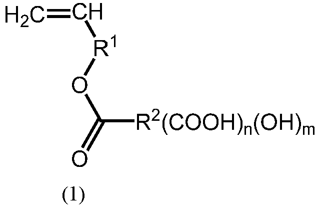
      - wherein R¹ is selected from a hydrocarbyl group having 2 to 10 carbon atoms, preferably 2 to 6 carbon atoms, more preferably 4 or 6 carbon atoms;
      - wherein R² is selected from a hydrocarbyl group having 2 to 10 carbon atoms, and
      - wherein 'n' is an integer from 1 to 3 and 'm' is an integer from 0 to 4, preferably 1 to 4. wherein the functionalized polyolefin comprises ≤ 0.8 wt%, preferably ≤ 0.5 wt%, preferably ≤ 0.2 wt%, of metal, based on the total weight of the functionalized polyolefin and determined using Inductively Coupled Plasma Mass Spectrometry done on an inorganic metal oxide presents within the functionalized polyolefin, preferably the inorganic metal oxide comprises a metal selected from Group 13 (Group III) of the Periodic Table, preferably the inorganic metal oxide is alumina or its hydrated analogues, aluminum hydroxide oxide or aluminum hydroxide.

Preferably, the present invention is achieved by a film comprising a functionalized polyolefin, wherein the functionalized polyolefin is a propylene terpolymer, comprising:
i. ≥ 80.0 mol% and ≤ 98.95 mol%, preferably ≥ 88.0 mol% and ≤ 98.0 mol%, preferably ≥ 90.0 mol% and ≤ 96.0 mol%, of polymeric units derived from propylene;
ii. ≥ 0.1 mol% and ≤ 19.95 mol%, preferably ≥ 1.0 mol% and ≤ 10.0 mol%, preferably ≥ 3.5 mol% and ≤ 9.9 mol%, of polymeric units derived from a first olefin monomer comprising either 2, or 4 to 8 carbon atoms, preferably the first olefin monomer comprises 2 or 6 carbon atoms; and
iii. ≥ 0.05 mol% and ≤ 5.0 mol%, preferably ≥ 0.1 mol% and ≤ 2.0 mol%, preferably ≥ 0.1 mol% and ≤ 0.5 mol%, of polymeric units derived from a functionalized olefin monomer,

based on the total moles of all polymeric units constituting the propylene terpolymer,
wherein the functionalized olefin monomer is a monomer selected from:
   a. a hydroxyl group containing olefin monomer having 4 to 12 carbon atoms, preferably 4 to 8 carbon atoms;
   b. a carboxylic acid containing olefin monomer having 2 to 12 carbon atoms, preferably 4 to 8 carbon atoms; and
   c. an esterified olefin monomer represented by formula (1): 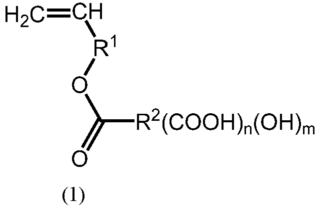
      - wherein R¹ is selected from a hydrocarbyl group having 2 to 10 carbon atoms, preferably 2 to 6 carbon atoms, more preferably 4 or 6 carbon atoms;
      - wherein R² is selected from a hydrocarbyl group having 2 to 10 carbon atoms, and
      - wherein 'n' is an integer from 1 to 3 and 'm' is an integer from 0 to 4.
wherein the functionalized polyolefin comprises ≤ 0.8 wt%, preferably ≤ 0.5 wt%, preferably ≤ 0.2 wt%, of metal, based on the total weight of the functionalized polyolefin and determined using Inductively Coupled Plasma Mass Spectrometry done on an inorganic metal oxide presents within the functionalized polyolefin, preferably the inorganic metal oxide comprises a metal selected from Group 13 (Group III) of the Periodic Table, preferably the inorganic metal oxide is alumina or its hydrated analogues, aluminum hydroxide oxide or aluminum hydroxide.

The term "hydrocarbyl" as used throughout this disclosure means a hydrocarbon group formed by removing one or more hydrogen atom from a hydrocarbon compound and such a group includes straight chain or branched hydrocarbons, saturated or unsaturated hydrocarbons, aliphatic and aromatic hydrocarbon groups.

The term "terpolymer" as used throughout this disclosure means a polymer molecule having polymeric units derived from three different monomers.

The term "copolymer" as used throughout this disclosure means a polymer molecule having polymeric units derived from at least two different monomers.

The symbol "≥" as used throughout this disclosure means any one of "greater than equal to" or "at least". For example, the term "≥ 95.0" means "greater than equal to 95.0" or "at least 95.0". The symbol "≤" as used throughout this disclosure means "less than equal to" or "not greater than". For example, the term "≤ 95.0" means "less than equal to 95.0" or "not greater than 95.0".

The film of the present invention may for example comprise the functionalized polyolefin to be present in an amount of ≥ 95.0 wt% and ≤ 100.0 wt%, preferably ≥ 96.0 wt% and ≤ 100.0 wt%, preferably ≥ 97.0 wt% and ≤ 100.0 wt%, preferably ≥ 98.0 wt% and ≤ 100.0 wt%, preferably ≥ 99.95 wt% and ≤ 100.0 wt%, preferably 100.0 wt% based on the total weight of the film. In some embodiments of the invention, the film can comprise a combination of a functionalized polyolefin and a polyolefin thermoplast, a polyolefin plastomer or a polyolefin elastomer.

Accordingly, in some embodiments of the invention, the film of the present invention may for example comprise a combination of a polyolefin thermoplast, a polyolefin plastomer or a polyolefin elastomer and the functionalized polyolefin wherein the functionalized polyolefin is present in an amount of ≥ 25.0 wt% and ≤ 95.0 wt%, preferably ≥ 30.0 wt% and ≤ 80.0 wt%, preferably ≥ 35.0 wt% and ≤ 75.0 wt%, preferably ≥ 40.0 wt% and ≤ 70.0 wt%, based on the total weight of the film.

Accordingly, in some embodiment of the invention, the film of the present invention may comprise a blend of the functionalized polyolefin with a non-functionalized polyolefin, preferably selected from the list comprising polyethylene, poly(ethylene-co-propylene), poly(ethylene-co-1-butene), poly(ethylene-co-1-hexene), poly(ethylene-co-1-octene), polypropylene, poly(propylene-*co*-ethylene), poly(propylene-*co*-1-butene), poly(propylene-*co*-1-hexene), poly(propylene-*co*-1-octene).

Advantageously, the film of the present invention demonstrates a suitable combination of one or more of (i) desirably high electrical resistance (or volume resistivity), (ii) excellent adhesion property (iii) excellent moisture and gas barrier property, (iv) ease of processability, (v) excellent optical transmittance, and (vi) suitable mechanical properties such as tensile modulus. The combination of one or more of such advantages properties, renders the film of the present invention particularly suitable to be an encapsulant film. As a further advantage, the film of the present invention imparts excellent adhesion and mechanical properties without the requirement of being chemically cross-linked, thereby leading to reduced processing time and rendering such films to be easily recyclable as compared to conventional films consisting of cross-linked polymers.

Accordingly, in some aspects of the invention, the invention is directed to the use of the film in accordance with one or more embodiments of the present invention, as an encapsulant film for a photovoltaic module.

### Non-functionalized Polyolefin

The non-functionalized polyolefin according to the invention suitable to be integrated in to the blend of the encapsulant film according to the invention is represented by formula (2): 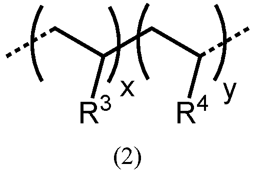 wherein
x is at least 50 mol%, preferably at least 80 mol%,
y is 0 or 100-(x) mol%,
R³ is H or CH₃,
R⁴ is selected from the list comprising: hydrocarbyl group having 0 to 10 carbon atoms, preferentially 1 to 6 and more preferentially 1 or 6 when R³ = H, and preferably 0, 2, 4 or 6 and more preferentially 0 or 4 when R³ = CH₃.

In some embodiment, the non-functionalized polyolefin is selected from the list comprising: polyethylene, poly(ethylene-*co*-propylene), poly(ethylene-co*-*1-butene), poly(ethylene-*co*-1-hexene), poly(ethylene-*co*-1-octene), polypropylene, poly(propylene-*co-*ethylene), poly(propylene-*co*-1-butene), poly(propylene-*co*-1-hexene), poly(propylene-*co*-1-octene).

### Functionalized Polyolefin

### Functionalized propylene copolymer

In some embodiments of the invention, the film may for example comprising a functionalized polyolefin, wherein the functionalized polyolefin may for example be a functionalized propylene copolymer. The functionalized propylene copolymer may for example comprise ≥ 95.0 mol% and ≤ 99.95 mol%, preferably ≥ 98.0 mol% and ≤ 99.95 mol%, preferably ≥ 99.0 mol% and ≤ 99.9 mol%, preferably ≥ 99.5 mol% and ≤ 99.9 mol%, of polymeric units derived from propylene and ≥ 0.05 mol% and ≤ 5.0 mol%, preferably ≥ 0.05 mol% and ≤ 2.0 mol%, preferably ≥ 0.1 mol% and ≤ 1.0 mol%, preferably ≥ 0.1 mol% and ≤ 0.5 mol%, of polymeric units derived from a functionalized olefin monomer, based on the total moles of all polymeric units constituting the functionalized propylene copolymer.

The functionalized propylene copolymer may for example comprise 96.0 mol%, 97.0 mol%, 98.0 mol%, 99.0 mol%, 99.5 mol%, 99.6 mol%, 99.7 mol%, 99.8 mol%, 99.9 mol% or 99.95 mol% of polymeric units derived from propylene, based on the total moles of all polymeric units constituting the propylene copolymer. The functionalized propylene copolymer may for example comprise 4.0 mol%, 3.0 mol%, 2.0 mol%, 1.0 mol%, 0.5 mol%, 0.4 mol%, 0.3 mol%, 0.2 mol%, 0.1 mol% or 0.05 mol%, of polymeric units derived from the functionalized olefin monomer, based on the total moles of all polymeric units constituting the functionalized propylene copolymer.

Preferably, in some embodiments of the invention, the functionalized propylene copolymer may comprise ≥ 98.0 mol% and ≤ 99.95 mol%, of polymeric units derived from propylene and ≥ 0.05 mol% and ≤ 2.0 mol%, of polymeric units derived from a functionalized olefin monomer, based on the total moles of all polymeric units constituting the functionalized propylene copolymer.

Preferably, in some embodiments of the invention, the functionalized propylene copolymer may comprise ≥ 99.0 mol% and ≤ 99.90 mol%, of polymeric units derived from propylene and ≥ 0.1 mol% and ≤ 1.0 mol%, of polymeric units derived from a functionalized olefin monomer, based on the total moles of all polymeric units constituting the functionalized propylene copolymer.

Preferably, in some embodiments of the invention, the functionalized propylene copolymer may for comprise ≥ 99.5 mol% and ≤ 99.90 mol%, of polymeric units derived from propylene and ≥ 0.1 mol% and ≤ 0.5 mol%, of polymeric units derived from a functionalized olefin monomer, based on the total moles of all polymeric units constituting the functionalized propylene copolymer.

### Functionalized propylene terpolymer

In some embodiments of the invention, the film may for example comprise a functionalized polyolefin, wherein the functionalized polyolefin may for example be a functionalized propylene terpolymer. The functionalized propylene terpolymer may for example comprises (i) ≥ 80.0 mol% and ≤ 98.95 mol%, of polymeric units derived from propylene, (ii) ≥ 0.1 mol% and ≤ 19.95 mol% of polymeric units derived from a second olefin monomer comprising either 2, or 4 to 8 carbon atoms, preferably the first olefin monomer comprises 2 or 6 carbon atoms, and (iii) ≥ 0.05 mol% and ≤ 5.0 mol%, of polymeric units derived from a functionalized olefin monomer, based on the total moles of all polymeric units constituting the functionalized propylene terpolymer.

The polymeric units derived from propylene may for example be present in an amount of 80.5 mol%, 86.0 mol%, 88.0 mol%, 91.0 mol%, 91.2 mol%, 92.0 mol%, 94.0 mol%, 98.0 mol% or 98.95 mol%. The polymeric units derived from a second olefin monomer may for example be present in amount of 0.1 mol%, 1.0 mol%, 4.5 mol%, 6.0 mol%, 8.5 mol%, 11.0 mol%, 15.0 mol% or 19.5 mol%. The polymeric units derived from the functionalized olefin monomer may for example be present in an amount of 0.05 mol%, 0.1 mol%, 0.5 mol%, 1.0 mol%, 2.0 mol%, 3.0 mol%, 4.0 mol% or 5.0 mol%.

Preferably, the functionalized propylene terpolymer may comprise (i) ≥ 88.0 mol% and ≤ 98.0 mol%, of polymeric units derived from propylene, (ii) ≥ 1.0 mol% and ≤ 10.0 mol% of polymeric units derived from a second olefin monomer comprising either 2, or 4 to 8 carbon atoms, preferably the first olefin monomer comprises 2 or 6 carbon atoms, preferably the first olefin monomer comprises 6 carbon atoms, and (iii) ≥ 0.1 mol% and ≤ 2.0 mol%, of polymeric units derived from a functionalized olefin monomer, based on the total moles of all polymeric units constituting the functionalized propylene terpolymer.

More preferably, the functionalized propylene terpolymer may comprise (i) ≥ 90.0 mol% and ≤ 96.0 mol%, of polymeric units derived from propylene, (ii) ≥ 3.5 mol% and ≤ 9.9 mol% of polymeric units derived from a second olefin monomer comprising either 2, or 4 to 8 carbon atoms, preferably the first olefin monomer comprises 2 or 6 carbon atoms, preferably the first olefin monomer comprises 6 carbon atoms, and (iii) ≥ 0.1 mol% and ≤ 0.5 mol%, of polymeric units derived from a functionalized olefin monomer, based on the total moles of all polymeric units constituting the functionalized propylene terpolymer.

### Ethylene terpolymer

In some embodiments of the invention, the film may for example comprise a functionalized polyolefin, wherein the functionalized polyolefin may for example be an ethylene terpolymer. The functionalized ethylene terpolymer may for example comprise (i) ≥ 80.0 mol% and ≤ 98.95 mol%, of polymeric units derived from ethylene, (ii) ≥ 0.1 mol% and ≤ 19.95 mol% of polymeric units derived from a second olefin monomer comprising 3 to 8 carbon atoms, preferably the second olefin monomer comprises 8 carbon atoms, and (iii) ≥ 0.05 mol% and ≤ 5.0 mol%, of polymeric units derived from a functionalized olefin monomer, based on the total moles of all polymeric units constituting the functionalized ethylene terpolymer.

The polymeric units derived from ethylene may for example be present in an amount of 80.5 mol%, 86.0 mol%, 88.0 mol%, 91.0 mol%, 91.2 mol%, 92.0 mol%, 94.0 mol%, 98.0 mol% or 98.95 mol%. The polymeric units derived from a second olefin monomer may for example be present in amount of 0.1 mol%, 1.0 mol%, 4.5 mol%, 6.0 mol%, 8.5 mol%, 11.0 mol.%, 15.0 mol% or 19.5 mol%. The polymeric units derived from the functionalized olefin monomer may for example be present in an amount of 0.05 mol%, 0.1 mol%, 0.5 mol%, 1.0 mol%, 2.0 mol%, 3.0 mol%, 4.0 mol% or 5.0 mol%, based on the total moles of all polymeric units constituting the functionalized ethylene terpolymer.

Preferably, the functionalized ethylene terpolymer may comprise (i) ≥ 90.0 mol% and ≤ 97.0 mol%, of polymeric units derived from ethylene, (ii) ≥ 2.5 mol% and ≤ 9.9 mol% of polymeric units derived from a second olefin monomer comprising 3 to 8 carbon atoms, preferably the second olefin monomer comprises 8 carbon atoms, and (iii) ≥ 0.1 mol% and ≤ 0.5 mol%, of polymeric units derived from a functionalized olefin monomer, based on the total moles of all polymeric units constituting the ethylene terpolymer.

Preferably, in some embodiments of the invention, when the first olefin of the functionalized terpolymer is propylene, the second olefin monomer comprising either 2 or 4 to 8 carbon atoms, is a monomer selected from ethylene, 1-butene, 1-hexene, 4-methyl-1-pentene, vinylcyclohexane, and 1-octene, preferably the second olefin monomer is selected from ethylene, or 1-hexene.

Preferably, in some embodiments of the invention, when the first olefin of the functionalized terpolymer is ethylene, the second olefin monomer comprising 3 to 8 carbon atoms is a monomer selected from propylene, 1-butene, 1-hexene, 4-methyl-1-pentene, vinylcyclohexane, and 1-octene, preferably the second olefin monomer is 1-octene.

Preferably, in some embodiments of the invention, (i) when the first olefin of the functionalized terpolymer is propylene, the second olefin monomer comprising either 2 or 4 to 8 carbon atoms, is a monomer selected from ethylene, 1-butene, 1-hexene, 4-methyl-1-pentene, vinylcyclohexane, and 1-octene, preferably the first olefin monomer is selected from ethylene, or 1-hexene; and/or (ii) when the first olefin of the functionalized terpolymer is ethylene, the second olefin monomer comprising 3 to 8 carbon atoms is a monomer selected from propylene, 1-butene, 1-hexene, 4-methyl-1-pentene, vinylcyclohexane, and 1-octene, preferably the second olefin monomer is 1-octene.

### Functionalized Olefin Monomer:

### Hydroxyl group containing olefin monomer

In some embodiments of the invention, the functionalized olefin monomer is a hydroxyl group containing olefin monomer having 4 to 12 carbon atoms, preferably 4 to 8 carbon atoms. Preferably, the hydroxyl group containing olefin monomer is selected from 3-buten-1-ol, 5-hexen-1-ol, 7-octen-1-ol, and 10-undecen-1-ol, preferably the hydroxyl group containing olefin monomer is 5-hexen-1-ol.

Accordingly, in some embodiments of the invention, the functionalized propylene copolymer may for example comprise polymeric units derived from propylene and polymeric units derived from the hydroxyl group containing olefin monomer having 4 to 12 carbon atoms, preferably 4 to 8 carbon atoms. Preferably, the propylene copolymer comprises polymeric units derived from propylene and polymeric units derived from 5-hexen-1-ol.

Accordingly, in some embodiments of the invention, the functionalized propylene terpolymer may for example comprise (i) polymeric units derived from propylene, (ii) polymeric units derived from a second olefin monomer comprising either 2, or 4 to 8 carbon atoms, preferably the second olefin monomer comprises 2 or 6 carbon atoms, preferably the second olefin monomer comprises 6 carbon atoms, and (iii) polymeric units derived from a hydroxyl group containing olefin monomer having 4 to 12 carbon atoms, preferably 4 to 8 carbon atoms.

Preferably, in some embodiments of the invention, the functionalized propylene terpolymer may comprise (i) polymeric units derived from propylene, (ii) polymeric units derived from a second olefin monomer comprising 6 carbon atoms, and (iii) polymeric units derived from 5-hexen-1-ol.

Preferably, in some embodiments of the invention, the functionalized propylene terpolymer may comprise (i) polymeric units derived from propylene, (ii) polymeric units derived from 1-hexene, and (iii) polymeric units derived from 5-hexen-1-ol.

Preferably, in some embodiments of the invention, the functionalized propylene terpolymer may comprise (i) polymeric units derived from propylene, (ii) polymeric units derived from ethylene, and (iii) polymeric units derived from 5-hexen-1-ol.

The functionalized ethylene terpolymer may for example comprise (i) polymeric units derived from ethylene, (ii) polymeric units derived from a second olefin monomer comprising 3 to 8 carbon atoms, preferably the second olefin monomer comprises 8 carbon atoms, and (iii) polymeric units derived from a hydroxyl group containing olefin monomer having 4 to 12 carbon atoms, preferably 4 to 8 carbon atoms.

### Carboxylic acid containing olefin monomer

In some embodiments of the invention, the functionalized olefin monomer is a carboxylic acid containing olefin monomer having 2 to 12 carbon atoms, preferably 4 to 8 carbon atoms. Preferably, in some embodiments of the invention, the carboxylic acid containing olefin monomer is selected from acrylic acid, 3-butenoic acid, 4-pentenoic acid, 5-hexenoic acid, 10-undecenoic acid, 5-norbornene-2-carboxylic acid and 5-norbornene-2-acetic acid, preferably the carboxylic acid containing olefin monomer is acrylic acid, 3-butenoic acid, 4-pentenoic acid and 5-norbornene-2-carboxylic acid.

Accordingly, the in some embodiments of the invention, the functionalized propylene copolymer may for example comprise (i) polymeric units derived from propylene and (ii) polymeric units derived from the carboxylic acid containing olefin monomer having 2 to 12 carbon atoms, preferably 4 to 8 carbon atoms.

In some embodiments of the invention, the functionalized propylene terpolymer may comprise (i) polymeric units derived from propylene, (ii) polymeric units derived from a second olefin monomer comprising either 2, or 4 to 8 carbon atoms, preferably the second olefin monomer comprises 2 or 6 carbon atoms, preferably the second olefin monomer comprises 6 carbon atoms, and (iii) polymeric units derived from the carboxylic acid containing olefin monomer having 2 to 12 carbon atoms, preferably 4 to 8 carbon atoms.

In some embodiments of the invention, the functionalized ethylene terpolymer may comprise (i) polymeric units derived from ethylene, (ii) polymeric units derived from a second olefin monomer comprising 3 to 8 carbon atoms, preferably the second olefin monomer comprises 8 carbon atoms, and (iii) polymeric units derived from the carboxylic acid containing olefin monomer having 2 to 12 carbon atoms, preferably 4 to 8 carbon atoms.

Preferably, in some embodiments of the invention, (i) the carboxylic acid containing olefin monomer is selected from acrylic acid, 3-butenoic acid, 4-pentenoic acid, 5-hexenoic acid, 10-undecenoic acid, 5-norbornene-2-carboxylic acid and 5-norbornene-2-acetic acid, preferably the carboxylic acid containing olefin monomer is acrylic acid, 3-butenoic acid, 4-pentenoic acid and 5-norbornene-2-carboxylic acid; and/or wherein (ii) the hydroxyl group containing olefin monomer is selected from 3-buten-1-ol, 5-hexen-1-ol, 7-octen-1-ol, and 10-undecen-1-ol, preferably the hydroxyl group containing olefin monomer is 5-hexen-1-ol.

The functionalized polyolefinhaving the carboxylic acid containing olefin monomer or the hydroxyl group containing olefin monomer, may for example be prepared by a solution process using a protected carboxylic acid containing olefin monomer or a protected hydroxyl group containing olefin monomer. Non-limiting examples of protection group includes silyl halides, trialkyl aluminum complexes, dialkyl aluminum alkoxide complexes, dialkyl magnesium complexes, dialkyl zinc complexes and trialkyl boron complexes, aluminum based compounds and complexes.

A purification step or a de-ashing step involving the removal of the protective agent that remain as impurities in the resin after the production process, is particularly preferred for the functionalized polyolefin especially for encapsulant film application for a photovoltaic module. By performing the purification (de-ashing) step, the film demonstrates improved adhesive strength and desirably increased volume resistivity. Inventors believe that by removing the protection groups from the resin, enables the film to have more hydroxyl functionalities available for enhancing both adhesive property and volume resistivity of the film.

### Esterified olefin monomer

In some embodiments of the invention, the functionalized olefin monomer is an esterified olefin monomer represented by formula (1): 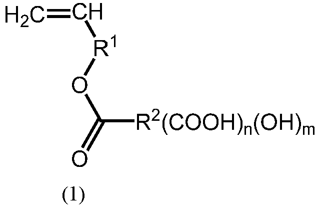
- wherein R¹ is selected from a hydrocarbyl group having 2 to 10 carbon atoms, preferably 2 to 6 carbon atoms, more preferably 4 or 6 carbon atoms;
- wherein R² is selected from a hydrocarbyl group having 2 to 10 carbon atoms, and
- wherein 'n' is an integer from 1 to 3 and 'm' is an integer from 0 to 4, preferably 1 to 4.

Accordingly, in some embodiments of the invention, the functionalized propylene copolymer may for example comprise polymeric units derived from propylene and polymeric units derived from the esterified olefin monomer.

In some embodiments of the invention, the functionalized propylene terpolymer may for example comprise (i) polymeric units derived from propylene, (ii) polymeric units derived from the first olefin monomer comprising either 2, or 4 to 8 carbon atoms, preferably the first olefin monomer comprises 2 or 6 carbon atoms, preferably the first olefin monomer comprises 6 carbon atoms, and (iii) polymeric units derived from the esterified olefin monomer.

In some embodiments of the invention, the functionalized ethylene terpolymer may for example comprise (i) polymeric units derived from ethylene, (ii) polymeric units derived from the second olefin monomer comprising 3 to 8 carbon atoms, preferably the second olefin monomer comprises 8 carbon atoms, and (iii) polymeric units derived from the esterified olefin monomer.

The functionalized polyolefin comprising polymeric units derived from the esterified olefin monomer may for example be prepared by first obtaining an intermediate functionalized polyolefin using a solution process. The intermediate functionalized polyolefin may for example comprise polymeric units derived from propylene, optionally polymeric units derived from a second monomer and polymeric units derived from the hydroxyl group containing olefin monomer.

Alternatively, the intermediate functionalized polyolefin may for example comprise polymeric units derived from ethylene, a second monomer and polymeric units derived from the hydroxyl group containing olefin monomer.

Subsequently, the intermediate functionalized polyolefin may be esterified with a poly-acid or the corresponding acid anhydride, preferably a di-acid or tri-acid moiety to obtain the functionalized polyolefin comprising polymeric units derived from the esterified olefin monomer. The poly-acid may for example have one or more hydroxyl group functionality. The step of esterification by a poly-acid or poly-acid anhydride can be performed using a solution process or during a reactive extrusion melt process.

The poly-acid and its corresponding acid anhydride may for example be selected from citric acid, citric acid anhydride, gluconic acid, glucaric acid, isocitric acid, tartaric acid, succinic acid, succinic acid anhydride, fumaric acid, malic acid, maleic acid anhydride, itaconoic acid, itaconoic acid anhydride, oxalic acid, trimesic acid, 1,2,4-benzenetricarboxylix-1,2-anhydride, propan-1,2-3-tricarboxylic acid, 2-phosphonobutane-1,2,4-tricarboxylic acid (PBTC), preferably the poly-acid is citric acid.

For the purpose of illustration, a functionalized propylene terpolymer as the intermediate functionalized polyolefinsuch as (poly(propylene-co-1-hexene-co-5-hexen-1-ol)) may be obtained by polymerizing propylene, 1-hexene and 5-hexen-1-ol in solution. Subsequently, the hydroxyl-functionalized propylene terpolymer may be esterified with citric acid to obtain a propylene terpolymer comprising polymeric units derived from propylene, 1-hexene and an esterified olefin monomer.

### Preferred Functionalized Polyolefin

In some embodiments of the invention, the functionalized polyolefin is selected from poly(C₃-*co*-C₂-*co*-C₆OH), poly(C₃-*co*-C₄-*co*-C₆OH), poly(C₃-*co*-C₆-*co*-C₆OH), poly(C₃-*co-*C₈-*co-*C₆OH), poly(C₃-*co*-C₆OH), poly(C₃-*co*-C₂-*co*-C₆OX), poly(C₃-*co*-C₆-*co*-C₆OX), or combinations thereof, preferably the functionalized polyolefin is selected from poly(C₃-*co*-C₂-*co-*C₆OH), poly(C₃-*co*-C₄-*co*-C₆OH), poly(C₃-*co*-C₆-*co*-C₆OH), poly(C₃-*co*-C₆-*co*-C₆OX), more preferably the functionalized polyolefin is poly(C₃-*co*-C₆-*co*-C₆OH), wherein C₂ represents ethylene monomer, C₃ represents propylene monomer, C₄ represents 1-butene monomer, C₆ represents 1-hexene monomer, C₈ represents 1-octene monomer and C₆OH represents 5-hexen-1-ol monomer, and 'X' represents a moiety derived from citric acid, citric acid anhydride, gluconic acid, glucaric acid, isocitric acid, tartaric acid, succinic acid, succinic acid anhydride, fumaric acid, malic acid, maleic acid anhydride, itaconoic acid, itaconoic acid anhydride, oxalic acid, trimesic acid, 1,2,4-benzenetricarboxylix-1,2-anhydride, propan-1,2-3-tricarboxylic acid, 2-phosphonobutane-1,2,4-tricarboxylic acid (PBTC), preferably 'X' is a moiety derived from citric acid.

Preferably, the film comprises a functionalized polyolefin , wherein the functionalized polyolefin is poly(C₃-*co*-C₆-*co*-C₆OH) wherein C₃ represents propylene monomer, C₆ represents 1-hexene monomer, and C₆OH represents 5-hexen-1-ol monomer, and wherein the functionalized polyolefin comprises ≤ 0.8 wt%, preferably ≤ 0.5 wt%, preferably ≤ 0.2 wt%, of metal, based on the total weight of the functionalized polyolefin and determined using Inductively Coupled Plasma Mass Spectrometry done on an inorganic metal oxide presents within the functionalized polyolefin, preferably the inorganic metal oxide comprises a metal selected from Group 13 (Group III) of the Periodic Table, preferably the inorganic metal oxide is alumina or its hydrated analogues, aluminum hydroxide oxide or aluminum hydroxide.

Preferably, the functionalized polyolefin is poly(propylene-co-1-hexene-co-5-hexen-1-ol) represented by the formula poly(C₃-*co*-C₆-*co*-C₆OH) wherein polymeric units derived from propylene is 91.2 mol%, polymeric units derived from 1-hexene is 8.5 mol%, and polymeric units derived from 5-hexen-1-ol content is 0.3 mol%, wherein the functionalized polyolefin comprises ≤ 0.8 wt%, preferably ≤ 0.5 wt%, preferably ≤ 0.2 wt%, of aluminum determined using Inductively Coupled Plasma Mass Spectrometry.

Alternatively, in some embodiments of the invention, the functionalized polyolefin is poly(propylene-co-1-hexene-co-5-hexen-1-ol) represented by the formula poly(C₃-*co*-C₆-*co-*C₆OH) wherein polymeric units derived from propylene is 88.0 mol%, polymeric units derived from 1-hexene is 11.5 mol%, and polymeric units derived from 5-hexen-1-ol is 0.5 mol%, wherein the functionalized polyolefin comprises ≤ 0.8 wt%, preferably ≤ 0.5 wt%, preferably ≤ 0.2 wt%, of aluminum determined using Inductively Coupled Plasma Mass Spectrometry.

Preferably, the functionalized polyolefin is poly(propylene-*co*-1-hexene-*co*-5-hexen-1-ol) represented by the formula poly(C₃-*co*-C₆-*co*-C₆OH) wherein polymeric units derived from propylene is 95.0 mol%, polymeric units derived from 1-hexene is 4.5 mol%, and polymeric units derived from 5-hexen-1-ol content is 0.5 mol%, wherein the functionalized polyolefin comprises ≤ 0.8 wt%, preferably ≤ 0.5 wt%, preferably ≤ 0.2 wt%, of aluminum determined using Inductively Coupled Plasma Mass Spectrometry.

### Ash Content and Polar Functionalization

Advantageously, the film comprising the functionalized polyolefin has a sufficiently low ash content or in other words sufficiently low metal oxide content. metal oxide such as alumina may be regarded as impurities often derived from residual traces of the catalyst composition (comprising co-catalyst or catalyst activator) ordinarily used for preparing the functionalized polyolefin. Alternatively, metal oxide may also originate from scavenger/protective agent that may be used for protecting hydroxyl or carboxylic acid functional groups present in the functionalized polyolefin.

It is suspected that the presence of the inorganic metal oxide beyond a certain threshold limit (or concentration) may adversely affect the performance of the film as an encapsulant for a photovoltaic module. For example, if the film has a high metal oxide content (e.g. greater than 0.8 wt%,), the film may be rendered stiff affecting its processability. Further, at such high content of metal may also affect the film's thermal and volume resistivity properties, thereby lowering its utility as an encapsulant film for a photovoltaic module, which require high electrical resistivity.

Preferably, in some embodiments of the invention, the functionalized polyolefin comprises ≤ 0.8 wt%, preferably ≤ 0.5 wt%, preferably ≤ 0.2 wt%, of metal based on the total weight of the functionalized polyolefin and determined using Inductively Coupled Plasma Mass Spectrometry done on an inorganic metal oxide presents within the functionalized polyolefin, preferably the inorganic metal oxide comprises a metal selected from Group 13 (Group III) of the Periodic Table, preferably the inorganic metal oxide is alumina or its hydrated analogues, aluminum hydroxide oxide or aluminum hydroxide.

More preferably, in some embodiments of the invention, the functionalized polyolefin comprises ≥ 0.0 wt% and ≤ 0.8 wt%, preferably ≥ 0.0 wt% and ≤ 0.5 wt%, preferably ≥ 0.0 wt% and ≤ 0.2 wt%, preferably ≥ 0.0 wt% and ≤ 0.1 wt%, of metal, based on the total weight of the functionalized polyolefin and determined using Inductively Coupled Plasma Mass Spectrometry done on an inorganic metal oxide presents within the functionalized polyolefin, preferably the inorganic metal oxide comprises a metal selected from Group 13 (Group III) of the Periodic Table, preferably the inorganic metal oxide is alumina or its hydrated analogues, aluminum hydroxide oxide or aluminum hydroxide.

The Inductively Coupled Plasma Mass Spectrometry (ICP-MS) may for example be performed by contacting a film sample under heat with a mineral acid such as nitric acid in a closed pressure vessel. The pressure vessel may for example be heated using microwave technology. The analysis is controlled via temperature and pressure sensors. The closed pressure vessel may for example be manufactured using fluoro-polymers (PTFE-TFM) or Quartz. The polymeric portion of the film sample may be disintegrated through the oxidative reaction of the acid to form carbon dioxide, water and nitrogen oxides while the residual metal oxide is converted to the corresponding nitrates, the content of which can be determined using ICP-MS to determine the amount of metal which refers to inorganic metal oxide presents within the functionalized polyolefin which present in the film sample. In other words, the ICP-MS analysis process involves a microwave assisted acid digestion process of a polymer sample using nitric acid followed by Inductively Coupled Plasma Mass Spectrometry analysis. In some aspects of the invention the Inductively Coupled Plasma Mass Spectrometry (ICP-MS) may be performed in accordance with ISO24047:2021.

Advantageously, the functionalized polyolefin has a suitable content of polar functional groups such as a hydroxyl functional group, which impart the desired adhesion properties to the film. It is believed that the tunable functionality of these functionalized polyolefin renders these class of polymers particularly suitable for gluing the polymers to various substrates such as metals, glass, wood and polar polymers. The general apolar nature of the functionalized polyolefin furthermore provides excellent adhesion to low surface energy substrates such as polyolefins (i.e. HDPE, LDPE, LLDPE, PP). Hence, the functional polyolefin adheres wellto the polar photovoltaic cells and to both polar (glass, metal) and apolar (polyolefin) front and back sheets of a photovoltaic module.

The polar groups such as the hydroxyl group may for example be determined using a ¹H NMR spectrum. Such an analysis may for example be carried out at 130 °C using deuterated tetrachloroethane (TCE-D2) as a solvent and recorded in a 5.0 mm tube on a Varian Mercury spectrometer operating at a frequency of 400 MHz. Chemical shifts may be reported in ppm versus tetramethylsilane and determined by reference relative to the solvent protons.

Preferably, the functionalized polyolefin has:
i) a metal content of ≥ 0.0 wt% and ≤ 0.8 wt%, preferably ≥ 0.0 wt% and ≤ 0.3 wt%, preferably ≥ 0.0 wt% and ≤ 0.2 wt%, preferably ≥ 0.01 wt% and ≤ 0.1 wt%, preferably ≥ 0.1 wt% and ≤ 0.2 wt%, based on the total weight of the functionalized polyolefin and determined using Inductively Coupled Plasma Mass Spectrometry; and
ii) a hydroxyl functional group content of ≥ 0.1 and ≤ 1.0 mol%, preferably ≥ 0.2 and ≤ 0.8 mol%, preferably ≥ 0.2 and ≤ 0.6 mol%, when determined using NMR spectroscopy.

### Preparation of the blend of non-functionalized polyolefin and functionalized polyolefin

In some embodiment, the blend of a non-functionalized polyolefin with the functionalized polyolefin according to the invention is produced by mixing the non-functionalized polyolefin and the functionalized polyolefin in the melt, using for example an extruder, or by dissolving the polymers in a common solvent followed by precipitation the polymer blend in a non-solvent or by flashing off the solvent in a devolatizer unit.

In another embodiment, the blend of a non-functionalized polyolefin with the functionalized polyolefin according to the invention is produced by a cascade solution polymerization process using two or more reactors in series where the non-functionalized polyolefin is being produced in one reactor and the functionalized polyolefin is produced in the other reactor, followed by flashing off the solvent in a devolatizer unit. This solution process is preferred as it allow a better blend of the functionalized polymer within the non-functionalized polymer at a molecular level than the melt extrusion process cannot achieve.

### Stabilizers and additives in the Film

Preferably, the film comprising the functionalized polyolefin may further comprise: ≥ 0.05 wt% and ≤ 5.0 wt% of one or more additives; with regard to the total weight of the film. The one or more additives may be selected from anti-oxidants, heat stabilizers, acid scavengers, plasticizers, hindered amine light stabilizer, antistatic additive, non-phenolic processing stabilizer, lubricants, scratch resistance agents, recycling additives, clarifying agent, processing stabilizers, microbials, anti-fogging additives, anti-blocking additives, non-phenolic processing stabilizer, and combinations thereof.

### Properties of the Functionalized Polyolefin

The functionalized polyolefin has a suitable balance of properties as required for the functionalized polyolefin to be used as an encapsulant film.

Preferably, the functionalized polyolefin has:
i) A metal content of ≥ 0.0 wt% and ≤ 0.8 wt%, preferably ≥ 0.0 wt% and ≤ 0.3 wt%, preferably ≥ 0.0 wt% and ≤ 0.2 wt%, preferably ≥ 0.01 wt% and ≤ 0.1 wt%, preferably ≥ 0.1 wt% and ≤ 0.2 wt%, based on the total weight of the functionalized polyolefin and determined using Inductively Coupled Plasma Mass Spectrometry; and/or
ii) a peak melting temperature (*T*ₘ) of ≥ 50.0 °C and ≤ 120.0 °C, preferably ≥ 70.0 °C and ≤ 100.0 °C, preferably ≥ 75.0 °C and ≤ 95.0 °C, preferably ≥ 75.0 °C and ≤ 90.0 °C as determined using differential scanning calorimetry (DSC) in accordance with ASTM D3418 (2008).

Preferably, the functionalized polyolefin has:
i) a hydroxyl functional group content of ≥ 0.1 and ≤ 1.0 mol%, preferably ≥ 0.2 and ≤ 0.8 mol%, preferably ≥ 0.2 and ≤ 0.6 mol%, when determined using NMR spectroscopy; and/or
ii) a Polydispersity Index (PDI) of ≥ 1.5 and ≤ 6.0, preferably ≥ 2.0 and ≤ 6.0, preferably ≥ 4.0 and ≤ 6.0, wherein PDI is calculated by dividing the weight average molecular weight (*M*_{w}) by the number average molecular weight (*M*ₙ) and wherein each of *M*_{w} and *M*ₙ are determined in accordance with ASTM D6474-12.

Preferably, the functionalized polyolefin has:
i) a weight average molecular weight (*M*_{w}) ≥ 75.0 kg/mol and ≤ 300.0 kg/mol, preferably ≥ 100.0 kg/mol and ≤ 150.0 kg/mol, and determined in accordance with ASTM D6474-12; and/or
ii) a crystallization temperature (*T_{c}*) of ≥ 20 °C and ≤ 80 °C, preferably ≥ 40 °C and ≤ 60 °C, preferably ≥ 35 °C and ≤ 55 °C, preferably ≥ 35 °C and ≤ 50 °C as determined using differential scanning calorimetry (DSC) in accordance with ASTM D3418 (2008); and/or
iii) a glass transition temperature (*T*_{g}) of ≥ -50.0 °C and ≤ 5.0 °C, preferably -10.0 °C and ≤ 2.0 °C, preferably ≥ -5.0 °C and ≤ 2.0 °C, preferably ≥ --2.0 °C and ≤ -1.0 °C as determined using dynamic mechanical thermal analysis (DMTA) in accordance with ISO 6721-10:2015.

More preferably, the functionalized polyolefin has:
i) A metal content of ≥ 0.0 wt% and ≤ 0.8 wt%, preferably ≥ 0.0 wt% and ≤ 0.3 wt%, preferably ≥ 0.0 wt% and ≤ 0.2 wt%, preferably ≥ 0.01 wt% and ≤ 0.1 wt%, preferably ≥ 0.1 wt% and ≤ 0.2 wt%, based on the total weight of the functionalized polyolefin and determined using Inductively Coupled Plasma Mass Spectrometry; and/or
ii) a peak melting temperature (*T*ₘ) of ≥ 50.0 °C and ≤ 120.0 °C, preferably ≥ 70.0 °C and ≤ 100.0 °C, preferably ≥ 75.0 °C and ≤ 95.0 °C, preferably ≥ 75.0 °C and ≤ 90.0 °C as determined using differential scanning calorimetry (DSC) in accordance with ASTM D3418 (2008); and/or
iii) a hydroxyl functional group content of ≥ 0.1 and ≤ 1.0 mol%, preferably ≥ 0.2 and ≤ 0.8 mol%, preferably ≥ 0.2 and ≤ 0.6 mol%, when determined using NMR spectroscopy; and/or
iv) a polydispersity Index (PDI) of ≥ 1.5 and ≤ 6.0, preferably ≥ 2.0 and ≤ 6.0, preferably ≥ 4.0 and ≤ 6.0, wherein PDI is calculated by dividing the weight average molecular weight (*M*_{w}) by the number average molecular weight (*M*ₙ) and wherein each of M_{w} and *M*ₙ are determined in accordance with ASTM D6474-12; and/or
v) a weight average molecular weight (*M*_{w}) ≥ 75.0 kg/mol and ≤ 300.0 kg/mol, preferably ≥ 100.0 kg/mol and ≤ 150.0 kg/mol and determined in accordance with ASTM D6474-12; and/or
vi) a crystallization temperature (*T_{c}*) of ≥ 20 °C and ≤ 80 °C, preferably ≥ 40 °C and ≤ 60 °C, preferably ≥ 35 °C and ≤ 55 °C, preferably ≥ 35 °C and ≤ 50 °C as determined using differential scanning calorimetry (DSC) in accordance with ASTM D3418 (2008); and/or
vii) a glass transition temperature (*T*_{g}) of ≥ -50.0 °C and ≤ 5.0 °C, preferably ≥ -10.0 °C and ≤ 2.0 °C, preferably ≥ -5.0 °C and ≤ 2.0 °C, preferably ≥ -2.0 °C and < - 1.0 °C as determined using dynamic mechanical thermal analysis (DMTA) in accordance with ISO 6721-10:2015.

More preferably, the functionalized polyolefin has:
i) A metal content of ≥ 0.0 wt% and ≤ 0.8 wt%, preferably ≥ 0.0 wt% and ≤ 0.3 wt%, preferably ≥ 0.0 wt% and ≤ 0.2 wt%, preferably ≥ 0.01 wt% and ≤ 0.1 wt%, preferably ≥ 0.1 wt% and ≤ 0.2 wt%, based on the total weight of the functionalized polyolefin copolymer and determined using Inductively Coupled Plasma Mass Spectrometry;
ii) a peak melting temperature (*T*ₘ) of ≥ 50.0 °C and ≤ 100.0 °C, preferably ≥ 70.0 °C and ≤ 100.0 °C, preferably ≥ 75.0 °C and ≤ 95.0 °C, preferably ≥ 75.0 °C and ≤ 90.0 °C as determined using differential scanning calorimetry (DSC) in accordance with ASTM D3418 (2008);
iii) a hydroxyl functional group content of ≥ 0.1 and ≤ 1.0 mol%, preferably ≥ 0.2 and ≤ 0.8 mol%, preferably ≥ 0.2 and ≤ 0.6 mol%, when determined using NMR spectroscopy;
iv) a polydispersity Index (PDI) of ≥ 1.5 and ≤ 6.0, preferably ≥ 2.0 and ≤ 6.0, preferably ≥ 4.0 and ≤ 6.0, wherein PDI is calculated by dividing the weight average molecular weight (*M*_{w}) by the number average molecular weight (*M*ₙ) and wherein each of M_{w} and *M*ₙ are determined in accordance with ASTM D6474-12;
v) a weight average molecular weight (*M*_{w}) ≥ 75.0 kg/mol and ≤ 300.0 kg/mol, preferably ≥ 100.0 kg/mol and ≤ 150.0 kg/mol and determined in accordance with ASTM D6474-12;
vi) a crystallization temperature (*T_{c}*) of ≥ 20 °C and ≤ 80 °C, preferably ≥ 40 °C and ≤ 60 °C, preferably ≥ 35 °C and ≤ 55 °C, preferably ≥ 35 °C and ≤ 50 °C as determined using differential scanning calorimetry (DSC) in accordance with ASTM D3418 (2008); and
vii) a glass transition temperature (*T*_{g}) of ≥ -50.0 °C and ≤ 5.0 °C, preferably -10.0 °C and ≤ 2.0 °C, preferably ≥ -5.0 °C and ≤ 2.0 °C, preferably ≥ -2.0 °C and ≤ -1.0 °C as determined using dynamic mechanical thermal analysis (DMTA) in accordance with ISO 6721-10:2015.

### Properties of the non-Functionalized Polyolefin

The non-functionalized polyolefin has a suitable balance of properties as required for the non-functionalized polyolefin to be used as an encapsulant film.

Preferably, the non-functionalized polyolefin has:
i) a peak melting temperature (*T*ₘ) of ≥ 50.0 °C and ≤ 120.0 °C, preferably ≥ 70.0 °C and ≤ 110.0 °C, preferably ≥ 75.0 °C and ≤ 100.0 °C as determined using differential scanning calorimetry (DSC) in accordance with ASTM D3418 (2008); and/or
ii) a polydispersity Index (PDI) of ≥ 1.5 and ≤ 6.0, preferably ≥ 2.0 and ≤ 6.0, preferably ≥ 4.0 and ≤ 6.0, wherein PDI is calculated by dividing the weight average molecular weight (*M*_{w}) by the number average molecular weight (*M*ₙ) and wherein each of M_{w} and *M*ₙ are determined in accordance with ASTM D6474-12; and/or
iii) a weight average molecular weight (*M*_{w}) ≥ 75.0 kg/mol and ≤ 300.0 kg/mol, preferably ≥ 100.0 kg/mol and ≤ 150.0 kg/mol and determined in accordance with ASTM D6474-12; and/or
iv) a crystallization temperature (*T_{c}*) of ≥ 20 °C and ≤ 80 °C, preferably ≥ 40 °C and ≤ 60 °C, preferably ≥ 35 °C and ≤ 55 °C, preferably ≥ 35 °C and ≤ 50 °C as determined using differential scanning calorimetry (DSC) in accordance with ASTM D3418 (2008); and/or
v) a glass transition temperature (*T*_{g}) of ≥ -50.0 °C and ≤ 5.0 °C, preferably ≥ -10.0 °C and ≤ 2.0 °C, preferably ≥ -5.0 °C and ≤ 2.0 °C, preferably ≥ -2.0 °C and ≤ - 1.0 °C as determined using dynamic mechanical thermal analysis (DMTA) in accordance with ISO 6721-10:2015.

### Properties of the Blend of Functionalized Polyolefin and non-Functionalized Polyolefin

Accordingly, in some embodiments of the invention, the blend of the present invention may for example comprise a combination of a polyolefin thermoplast, a polyolefin plastomer or a polyolefin elastomer and the functionalized polyolefin wherein the functionalized polyolefin is present in an amount of ≥ 25.0 wt% and 100 wt%, preferably ≥ 25.0 wt% and ≤ 95.0 wt%, preferably ≥ 30.0 wt% and ≤ 80.0 wt%, preferably ≥ 35.0 wt% and ≤ 75.0 wt%, preferably ≥ 40.0 wt% and ≤ 70.0 wt%, preferably ≥ 45 wt% and ≤ 55wt%, preferably 50 wt%, based on the total weight of the blend.

### Properties of the Film comprising the blend of Functionalized Polyolefin Polymer and non-Functionalized Polyolefin

The film of the present invention comprising the functionalized polyolefin and non-functionalized polyolefin, demonstrates suitable properties of electrical resistivity, optical and mechanical properties as required for the film to be used as an encapsulant film for a photovoltaic module.

Preferably, the film exhibits a volume resistivity of ≥ 1.0 × 10¹³ and ≤ 3.0 × 10¹⁶, preferably ≥ 1.0 × 10¹⁴ and ≤ 2.5 × 10¹⁵, preferably ≥ 1.0 × 10¹⁴ and ≤ 2.0 × 10¹⁴ when determined in accordance with ASTM D257-14 (2021) at an applied voltage of 1000 V for a time period of 600 seconds and at a temperature of 25 °C. At such volume resistivity, the film has the desired electrical resistivity required for a photovoltaic module.

Preferably, the film exhibits:
**a.** a volume resistivity of ≥ 1.0 × 10¹³ and ≤ 3.0 × 10¹⁶, preferably ≥ 1.0 × 10¹⁴ and ≤ 2.5 × 10¹⁵, preferably ≥ 1.0 × 10¹⁴ and ≤ 2.0 × 10¹⁴ when determined in accordance with ASTM D257-14 (2021) at an applied voltage of 1000 V for a time period of 600 seconds and at a temperature of 25 °C; and/or
**b.** an optical transmittance of ≥ 30.0 % and ≤ 95.0 %, preferably ≥ 40.0 % and ≤ 95.0 %, preferably ≥ 44.0 % and ≤ 85.0 %, preferably ≥ 45.0 % and ≤ 60.0 %, preferably ≥ 45.0 % and ≤ 50.0 %, when determined in accordance with ASTM D1003 (2021).

Preferably, the film exhibits:
**a.** a tensile strength at break of ≥ 15.0 MPa and ≤ 60.0 MPa, preferably ≥ 15.0 MPa and ≤ 60.0 MPa, preferably ≥ 20.0 MPa and ≤ 40.0 MPa, preferably ≥ 22.0 MPa and ≤ 30.0 MPa, when determined in accordance with ASTM D882 (2018); and/or
**b.** a tensile modulus of ≥ 30.0 MPa and ≤ 130.0 MPa, preferably ≥ 30.0 MPa and ≤ 100.0 MPa, preferably ≥ 30.0 MPa and ≤ 80.0 MPa, preferably ≥ 30.0 MPa and ≤ 60.0 MPa, preferably ≥ 35.0 MPa and ≤ 55.0 MPa, preferably ≥ 40.0 MPa and ≤ 50.0 MPa, when determined in accordance with ASTM D882 (2018).

More preferably, the film exhibits:
**a.** a volume resistivity of ≥ 1.0 × 10¹³ and ≤ 3.0 × 10¹⁶, preferably ≥ 1.0 × 10¹⁴ and ≤ 2.5 × 10¹⁵, preferably ≥ 1.0 × 10¹⁴ and ≤ 2.0 × 10¹⁴ when determined in accordance with ASTM D257-14 (2021) at an applied voltage of 1000 V for a time period of 600 seconds and at a temperature of 25 °C;
**b.** an optical transmittance of ≥ 30.0 % and ≤ 95.0 %, preferably ≥ 40.0 % and ≤ 95.0 %, preferably ≥ 44.0 % and ≤ 85.0 %, preferably ≥ 45.0 % and ≤ 60.0 %, preferably ≥ 45.0 % and ≤ 50.0 %, when determined in accordance with ASTM D1003 (2021);
**c.** a tensile strength at break of ≥ 15.0 MPa and ≤ 60.0 MPa, preferably ≥ 15.0 MPa and ≤ 60.0 MPa, preferably ≥ 20.0 MPa and ≤ 40.0 MPa, preferably ≥ 22.0 MPa and ≤ 30.0 MPa, when determined in accordance with ASTM D882 (2018); and
**d.** a tensile modulus of ≥ 30.0 MPa and ≤ 130.0 MPa, preferably ≥ 30.0 MPa and ≤ 100.0 MPa, preferably ≥ 30.0 MPa and ≤ 80.0 MPa, preferably ≥ 30.0 MPa and ≤ 60.0 MPa, preferably ≥ 35.0 MPa and ≤ 55.0 MPa, preferably ≥ 40.0 MPa and ≤ 50.0 MPa, when determined in accordance with ASTM D882 (2018).

The film may for example have a suitable moisture barrier property. For example the film of the present invention has a Water Vapor Transmission Rate (WVTR) of ≥ 0.5 g/(m²·day) and ≤ 8.0 g/(m²·day), when determined at 23°C at 85% relative humidity (R_{H}) in accordance with ASTM F1249.

### Preparation of the Film comprising the blend of Functionalized Polyolefin and non-Functionalized Polyolefin

The film comprising the functionalized polyolefin and non-functionalized polyolefin may be prepared by using a suitable process such as film extrusion/casting, or by compression molding. Accordingly, in some aspects of the invention, the invention relates to a process for preparing the film according to any one or more embodiments of the present invention, wherein the process comprises at least one step involving any one of (i) film extrusion and casting, or (ii) compression molding. Preferably the process for preparing the film comprises a step of film extrusion and casting, comprising the steps of:
**a.** providing the blend of functionalized polyolefin and non-functionalized polyolefin according to one or more embodiments of the present invention;
**b.** extruding the blend of functionalized polyolefin and non-functionalized polyolefin at a melt temperature of ≤ 225 °C and forming and extrudate; and
**c.** cooling the extrudate and forming the film.

In some embodiments of the invention, the extrusion is carried out at a melt temperature of ≤ 225 °C, preferably ≤ 210 °C, preferably ≤ 190 °C. Preferably, the extrusion is carried out at a melt temperature of ≥ 140 °C and ≤ 225 °C, preferably ≥ 150 °C and ≤ 210 °C, preferably ≥ 160 °C and ≤ 200 °C and forming the extrudate.

The cooling of the extrudate may involve the step of casting the film. For example, the process for preparing the film comprises a step of casting the extrudate at a temperature of ≤ 100 °C and forming the film. The casting of the film may for example be carried out at any suitable temperature of ≥ 70°C and ≤ 100°C. In some embodiments of the invention, the film so obtained may be further heated and subsequently stretched to form an oriented film, for example a bidirectionally oriented film.

Alternatively, in some aspects of the invention, the invention relates to a process for preparing the film according to one or more embodiments of the present invention, wherein the process comprises the step of compression molding, comprising the steps of:
a. providing the blend of functionalized polyolefin and non-functionalized polyolefin according to one or more embodiments of the present invention;
b. heating the blend of functionalized polyolefin and non-functionalized polyolefin at any temperature ≥ 150 °C and ≤ 225 °C, preferably ≥ 160 °C and ≤ 200 °C, and forming a precursor molten film;
**c.** applying a compression force of ≥ 50 kN and ≤ 150 kN, preferably ≥ 80 kN and ≤ 120 kN on the precursor film for a time period of ≥ 1.0 minute and ≤ 15.0 minutes, preferably ≥ 2.0 minutes and ≤ 8.0 minutes; and
**d.** cooling the precursor molten film to a temperature of ≥ 35 °C and ≤ 50 °C at a cooling rate of 10 °C/min and under a compression force of ≥ 50 kN and ≤ 150 kN, preferably ≥ 80 kN and ≤ 120 kN and forming the precursor film; and
**e.** removing the compression force and cooling the precursor film to ambient room temperature to obtain the film.

Optionally, the precursor molten film may be stabilized in the absence of any compression force for a time period of ≥ 1.0 minute and ≤ 15.0 minutes, preferably ≥ 2.0 minutes and ≤ 8.0 minutes prior to application of the compression force. The film, once formed, may be used for forming encapsulating or sealing layers suitable to be used in photovoltaic modules or other electronic modules. The film may have a suitable thickness as may be required for a particular application. For example, the film has a cross-sectional thickness of ≥ 200 µm and ≤ 3000 µm, preferably ≥ 200 µm and ≤ 800 µm, preferably ≥ 300 µm and ≤ 500 µm.

### Solar cell application:

Accordingly, in some embodiments of the invention, the invention is directed to an encapsulated solar cell comprising a solar cell positioned between a first encapsulant layer and a second encapsulant layer, wherein at least one of the first encapsulant layer or the second encapsulant layer, preferably each of the first encapsulant layer and the second encapsulant layer, comprises or consists of the film according to one or more embodiments of the present invention, further wherein the solar cell is positioned such that the first encapsulant layer and the second encapsulant layer are j oined so as to at least partially encapsulate the solar cell.

Solar cell used for the context of the present invention are known to a person skilled in the art. For example, the solar cell may be any standard commercially available crystalline or amorphous silicon solar cell or CIGS (copper indium gallium selenide) thin film. The person skilled in the art may know what type of electrical connection to use, for example electrical conductors may be metal strips such as strips comprising copper aluminum and/or silver or, in the alternative, may be metal wires.

In some aspects of the invention, the invention is directed to a photovoltaic module comprising the encapsulated solar cell in accordance with the present invention, preferably wherein the photovoltaic module comprises:
**a.** a front layer;
**b.** a back layer; and
**c.** the encapsulated solar cell, wherein the encapsulated solar cell is positioned between the front layer and the back layer preferably such that the front layer is in direct contact with the first encapsulant layer and the second encapsulant layer is in direct contact with the back layer.

In some embodiments of the invention, the invention is directed to a photovoltaic module comprising the encapsulated solar cell in accordance with the present invention, preferably wherein the photovoltaic module comprises in the order of:
**a.** a front layer;
**b.** a first encapsulant layer;
**c.** a solar cell;
**d.** a second encapsulant layer; and
**e.** a back layer;
wherein the solar cell is positioned between the first encapsulant layer and the second encapsulant layer, preferably the front layer is in direct contact with the first encapsulant layer and the second encapsulant layer is in direct contact with the back layer.

In some embodiments of the invention, the front layer and/or the back layer comprises a material selected from the group consisting of a polypropylene composition, glass, polycarbonate composition, and any combinations thereof, preferably the front layer and/or the back layer comprise(s) a polypropylene composition. The polypropylene composition may for example comprise a polypropylene homopolymer in particular an iso-tactic polypropylene (iPP) optionally comprising inorganic fillers such as glass or talcum. Alternatively, the polypropylene composition may for example be a propylene-ethylene random copolymer (random PP).

In some embodiments of the invention, the front layer and/or the back layer comprises a polypropylene composition. The front layer suitable for the present invention may for example be identical to that described on pages 3-9 of the published patent application WO2021053180A1 while the back layer suitable for the present invention may for example be identical to that described on pages 12-17 of the published patent application WO2021053180A1.

In addition to the front layer, the sealing layer and the back layer, the photovoltaic module may further comprise additional layers such as a protective (UV and/or fire) coating on the sunlight facing side of the front layer. Preferably, the photovoltaic module of the invention does not comprise a metal layer, rendering the process of recycling of the photovoltaic module of the invention easier.

The photovoltaic module may for example be manufactured by a suitable process. For example, in some aspects of the invention, the invention is directed to process for making the photovoltaic module in accordance with one or more embodiments of the invention, wherein the process comprises the step of:
a) assembling the front layer, the first encapsulant layer, the solar cell, the second encapsulant layer and the back layer to form a photovoltaic assembly such that the solar cell is positioned between the first encapsulant layer and the second encapsulant layer, preferably such that the front layer is in direct contact with the first encapsulant layer; and the second encapsulant layer is in direct contact with the back layer;
b) heating the photovoltaic assembly at a temperature such that at least a portion of the first encapsulant layer and the second encapsulant layer melt to form a melted photovoltaic assembly comprising the solar cell;
c) pressing the melted photovoltaic assembly under heated conditions and forming the laminated photovoltaic module; and
d) cooling the laminated photovoltaic module to ambient temperature and obtaining the photovoltaic module.

Preferably, the ambient temperature suitable for the process for producing the photovoltaic module may be ≥ 15.0 °C and ≤ 35.0 °C, preferably ≥ 20.0 °C and ≤ 35.0 °C.

Preferably, the photovoltaic assembly is heated at any temperature of ≥ 110.0 °C and ≤ 180.0 °C, preferably ≥ 120.0 °C and ≤ 170.0 °C, preferably ≥ 125.0 °C and ≤ 165.0 °C, preferably ≥ 130.0 °C and ≤ 160.0 °C. Preferably in the heating step, the assembly is heated to a temperature such that the front and back layer do not melt, for example the temperature of this heating step is chosen such that the front layer obtains a temperature of at least 5°C below the melting temperature of the front layer.

In practice, the temperature of the heating step is chosen as high as possible so as to allow maximum adherence between the first encapsulant layer and the front layer and the adhesion of the second encapsulant layer and the back layer, while ensuring that the polymeric front and the back layer does not melt.

During such lamination process, the structural integrity of the back layer and of the assembly is maintained and the photovoltaic module of the invention can be prepared with consistent dimensions. Furthermore, lamination is an easy process which has short cycle times as it can be performed at high speed. It should be clear to the person skilled in the art, that the layers may also be laminated in part. For example, the front and the first encapsulating layer may first be laminated onto one another, after which the laminated front and sealing layer may be laminated onto the back layer.

Specific examples demonstrating some of the embodiments of the invention are included below.

### EXAMPLES

**Purpose:** For the purposes of exemplifying the present invention, three film samples were prepared. Film sample 'IE' represent a film in accordance with the present invention, inventive formulations, the films CE1 and CE2 are comparative formulations, whose performance is compared with. The details of the film samples are provided below:

**Table 1**

| Example | Polymer | Description |
|---|---|---|
| **CEI (Comparative) Pure FPO** | Poly (C₃-CO-C₆-CO-C₆OH) | - A terpolymer having polymeric units derived from propylene, 1-hexene and 5-hexen-1-ol monomer. |
| | | - (Metal) Aluminum content is 0.168 wt.%. |
| | | - C₃ (propylene) content is 91.2 mol.% |
| | | - C₆ (1-hexene) content is 8.5 mol.% |
| | | - C₆OH (5-hexen-1-ol) content is 0.3 mol.% |
| | | - Hydroxyl group content is 0.3 mol.% |
| **CEII (Comparative) Non-functionalized polyolefin** | Poly (C₃-co-C₆) | - A copolymer having polymeric units derived from propylene and 1-hexene |
| | | - (Metal) Aluminum content is 0.170 wt.%. |
| | | - C₃ (propylene) content is 91.7 mol.% |
| | | - C₆ (1-hexene) content is 8.3 mol.% |
| **EI (Inventive)** | Blend of poly (C₃-co-C₆-co-C₆OH) with poly (C₃-co-C₆) | - A blend comprising 50 %wt poly (C₃-co-C₆-co-C₆OH) and 50 %wt poly (C₃-co-C₆) |
| | | - (Metal) Aluminum content is 0.19.%. |
| | | - Hydroxyl group content is 0.2 mol.% |

### Method of preparation of the functionalized polyolefin polymer : poly (C₃-co-C₆-co-C₆OH):

The polymerization experiment was carried out using a stainless steel BÜCHI reactor (2 L) filled with pentamethylheptane (PMH) solvent (1 L) using a stirring speed of 600 rpm. Catalyst and comonomer solutions were prepared in a glove box under an inert dry nitrogen atmosphere.

The reactor was first heated to 40 °C followed by the addition of TiBA (1.0 M solution in toluene, 2 mL), 1-hexene (neat 10 mL), and triethylaluminum (TEA)-pacified 5-hexen-1-ol (1.0 M solution in toluene, TEA:5-hexen-1-ol (mol ratio) = 1, 10 mL). The reactor was charged at 40 °C with gaseous propylene (100 g) and the reactor was heated up to the desired polymerization temperature of 130 °C resulting in a partial propylene pressure of about 15 bar. Once the set temperature was reached, the polymerization reaction was initiated by the injection of the pre-activated catalyst precursor bis((2-oxoyl-3-(dibenzo-1H-pyrrole-1-yl)-5-(methyl)phenyl)-2-phenoxy)-2,4-pentanediylhafnium (IV) dimethyl [CAS 958665-18-4]; other name hafnium [[2',2‴-[(1,3-dimethyl-1,3-propanediyl)bis(oxy-κO)]bis[3-(9H-carbazol-9-yl)-5-methyl[1,1'-biphenyl]-2-olato-κO]](2-)]dimethyl] (Hf-O4, 2 µmol) in MAO (30 wt % solution in toluene, 11.2 mmol). The reaction was stopped by pouring the polymer solution into a container flask containing demineralized water/iPrOH (50 wt%, 1 L) and Irganox 1010 (1.0 M, 2 mmol). The resulting suspension was filtered and dried at 80 °C in a vacuum oven, prior the addition of Irganox 1010 as an antioxidant. The poly(propylene-co-1-hexene-co-5-hexen-1-ol) (25.6 g) was obtained as a white powder. The copolymer obtained from the solution process may be de-ashed in order to remove trace of protective compounds used during polymer synthesis or remove traces of alumina or its hydrated analogues, aluminum hydroxide oxide or aluminum hydroxide derived from catalyst residues. To do so the polymer (10g) was dispersed in mixture of dry toluene (400 ml) and concentrated (37%) HCl (10 ml, 0.13 mol, 4.74 g) and heated under reflux until the terpolymer dissolved. Once the polymer was properly dissolved, methanol (250 ml) was added to the hot mixture and the mixture was heated under stirring at 90 - 100 °C for 1 additional hour. Then the polymer was precipitated in cold methanol, filtered and washed 2 × with methanol and dried at 60 °C under reduced pressure.

### Preparation of blend comprising 50%wt poly(C3-co-C6-co-C6OH) and 50%wt poly(C3-co-C6).

Solid hydroxyl functionalized propylene-based terpolymer poly(C3-co-C6-co-C6OH) (5 g) and non-functionalized polyolefin poly(C₃-co-C₆) (5 g) were dispersed in toluene (400 mL) and the mixture was heated under nitrogen at 100 °C and stirring at 500 rpm until the polymers dissolved. Then the polymer was precipitated in cold methanol (500 mL), filtered and washed 2 x with methanol.

### Process of preparing the film of the blend:

The film of the blend samples (EI), were prepared via compression-molding using PP ISO settings on LabEcon 600 high-temperature press (Fontijne Presses, the Netherlands). The compression-molding cycle was applied: heating to 180 °C, stabilizing for 5 min with no force applied, 5 min with 100 kN normal force and cooling down to 40 °C with 10 °C/min and 100 kN normal force and obtaining the film.

### Testing Parameters and methodology:

The evaluation parameters were determined in accordance with the methodology provided below:

### Procedure to determine aluminum content (ICP-MS test method):

De-ashed poly(C₃-co-C₆-co-C₆OH) (0.4 mol% OH; PDI = 4.6; 150 mg (5.6·10⁻⁶ mol)) was digested in 6 mL concentrated nitric acid (trace metal grade) by microwave assisted acid digestion using an Anton Paar Multiwave PRO equipped with closed high pressure Quartz digestion vessels. After the microwave digestion run, the acid was analytically transferred into a pre-cleaned plastic centrifuge tube containing 1 mL of internal standard solution and was diluted with MilliQ water up to the 50 mL mark. The elements in the sample were quantified using a multielement calibration set from Inorganic Ventures using an Agilent 8900 ICP-MS system.

### Volume resistivity:

determined in accordance with ASTM D257-14 (2021) at an applied voltage of 1000V for a time period of 600 seconds and at a temperature of 25°C.

### Quantity of hydroxyl functionality:

The functionality level was determined by ¹H NMR spectroscopy by comparing the integration of the CH₂ signals next to the hydroxyl (OH) with the integration of the resonances of the polymer backbone. Analysis was carried out at 130 °C using deuterated tetrachloroethane (TCE-D2) as solvent and recorded in 5 mm tubes on a Varian Mercury spectrometer operating at a frequency of 400 MHz. Chemical shifts are reported in ppm versus tetramethylsilane and were determined by reference to the residual solvent protons.

### Peak melting temperature (Tₘ):

The peak melting temperature was determined in accordance with ASTM D3418-15, using Differential Scanning Calorimetry (DSC) with a first heating and cooling cycle at a temperature between -40 °C to 230 °C and at a heating and a cooling rate of 10 °C/min for a 3-6 mg film sample, using a nitrogen purge gas at a flow rate of 50 ± 5 mL/min, followed by a second heating cycle identical to the first heating cycle.

### Crystallization temperature (T_{c}):

determined in accordance with ASTM D3418-15, using Differential Scanning Calorimetry (DSC) with a first heating and cooling cycle at a temperature between -40 °C to 230 °C and at a heating and a cooling rate of 10 °C/min for a 3-6 mg film sample, using a nitrogen purge gas at flow rate of 50 ± 5 mL/min, followed by a second heating cycle identical to the first heating cycle.

### Weight average molecular weight (M_{w}) and Number average molecular weight (Mₙ):

*M*_{w} and *M*ₙ are determined in accordance with ASTM D6474-12.

### Polydispersity Index (PDI):

PDI is calculated by dividing the weight average molecular weight (*M*_{w}) by the number average molecular weight (*M*ₙ) and wherein each of *M*_{w} and *M*ₙ are measured in accordance with ASTM D6474-12.

### Tensile modulus and Tensile strength at break:

determined in accordance with ASTM D882 (2018).

### Glass transition temperature (T_{g}):

*T*_{g} is determined by DMTA in accordance with ISO 6721-10:2015.

### Results:

The results from the test analysis is provided in the table below:

**Table 3**

| Sample | Composition | C₆ | OH | Residues aluminum | Mw | PDI | Tm | Tc | Tg |
|---|---|---|---|---|---|---|---|---|---|
| | | content | content | | | | | | |
| | | mol % | mol % | wt % | kg/ | - | °C | °C | °C |
| | | | | | mol | | | | |
| Comparative Example (CE1) | poly (C₃-CO-C₆-co-C₆OH) | 8.5 | 0.4 | 0.876 | 121.2 | 4.6 | 90.8 | 16.9 | 1.7 |
| Comparative Example (CE2) | poly (C₃-CO-C₆-co-C₆) | 8.7 | 0.2 | 0.19 | 249.8 | 4.0 | 77.3 | 27.5 | 3.1 |
| Inventive Example (IE) | poly (C₃-co-C₆-co-C₆OH) | 8.4 | 0.2 | 0.37 | 249.2 | 4.0 | 77.3 | 44.1 | 1.3 |

From the Polydispersity Index (PDI), the inventive functionalized polyolefin polymer has a higher Polydispersity Index and lower glass transition temperature Tg, indicative of improved processability of the polymer compared to the comparative polymer CE2. Further, the inventive polymer has a higher molecular weight contributing to the improved structural integrity of the film.

The performance of the film samples are provided in the table below:

**Table 3**

| Sample | Volume Resistivity | Tensile Modulus (MPa) | Tensile strength (MPa) | Elongation at break % |
|---|---|---|---|---|
| | Ω.cm | | | |
| CE1 | 1.90E+12 (1.9 × 10¹²) | 137.7 | 25.2 | 720 ± 9 |
| CE2 | 7.10E+13 (7.1 × 10¹³) | 20.1 | 9.5 | 924 ± 59 |
| IE | 1.10E+14 (1.1 × 10¹⁴) | 47.3 | 25.6 | 752 ± 33 |

From the data provided in Table 3, it is evident that the inventive film 'IE' demonstrates higher volume resistivity (Ω.cm) than that of CE1 and CE2, rendering the film to be particularly useful for application in photovoltaic module. For example, the inventive film 'IE' having functionalized polyolefin polymer has nearly 60 times higher volume resistivity than that of CE1, while the film 'IE' has a nearly 1.6 times higher volume resistivity than that of CE2. A comparison between the volume resistivity function of the inventive film 'IE' in comparison to 'CE1' indicates that a de-ashed polymer is particularly suitable for use in encapsulant films having high electrical resistance.

The inventive film 'IE' has a significantly lower (nearly 66% lower) tensile modulus or stiffness thereby allowing for improved processing of the film as compared to the film CE1. Further, the higher tensile strength at break for the inventive film compared to the film CE2, renders the film to have excellent mechanical properties, required for the film to be used as an encapsulant film.

Accordingly, the inventive film 'IE' comprising a functionalized polyolefin polymer such as propylene terpolymer of the formula poly (C₃-co-C₆-co-C₆OH) and having an aluminum content of around 0.168 wt%, imparts the desired properties of electrical resistivity, and mechanical properties that is suitable for use as an encapsulant film for a photovoltaic module.

## Claims

1. A film comprising a blend of non-functionalized polyolefin and functionalized polyolefin polymer,
wherein the non-functionalized polyolefin is a polymer selected from the group consisting of polyolefin thermoplast, polyolefin plastomer and polyolefin elastomer, and
wherein the functionalized polyolefin polymer is a polymer selected from the group consisting of:
a. a propylene copolymer comprising
i. ≥ 95.0 mol% and ≤ 99.95 mol%, preferably ≥ 98.0 mol% and ≤ 99.95 mol%, preferably ≥ 99.0 mol% and ≤ 99.9 mol%, preferably ≥ 99.5 mol% and ≤ 99.9 mol%, of polymeric units derived from propylene, and
ii. ≥ 0.05 mol% and ≤ 5.0 mol%, preferably ≥ 0.05 mol% and ≤ 2.0 mol%, preferably ≥ 0.1 mol% and ≤ 1.0 mol%, preferably ≥ 0.1 mol% and ≤ 0.5 mol%, of polymeric units derived from a functionalized olefin monomer,
based on the total moles of all polymeric units constituting the propylene copolymer;
b. a propylene terpolymer comprising
i. ≥ 80.0 mol% and ≤ 98.95 mol%, preferably ≥ 88.0 mol% and ≤ 98.0 mol%, preferably ≥ 90.0 mol% and ≤ 96.0 mol%, of polymeric units derived from propylene;
ii. ≥ 0.1 mol% and ≤ 19.95 mol%, preferably ≥ 1.0 mol% and ≤ 10.0 mol%, preferably ≥ 3.5 mol% and ≤ 9.9 mol%, of polymeric units derived from a first olefin monomer comprising either 2, or 4 to 8 carbon atoms, preferably the first olefin monomer comprises 2 or 6 carbon atoms; and
iii. ≥ 0.05 mol% and ≤ 5.0 mol%, preferably ≥ 0.1 mol% and ≤ 2.0 mol%, preferably ≥ 0.1 mol% and ≤ 0.5 mol%, of polymeric units derived from a functionalized olefin monomer,
based on the total moles of all polymeric units constituting the propylene terpolymer;
c. an ethylene terpolymer comprising:
i. ≥ 80.0 mol% and ≤ 98.95 mol%, preferably ≥ 90.0 mol% and ≤ 97.0 mol%, of polymeric units derived from ethylene,
ii. ≥ 0.1 mol% and ≤ 19.95 mol%, preferably ≥ 2.5 mol% and ≤ 9.9 mol%, of polymeric units derived from a second olefin monomer comprising 3 to 8 carbon atoms, preferably the second olefin monomer comprises 8 carbon atoms; and
iii. ≥ 0.05 mol% and ≤ 5.0 mol%, preferably ≥ 0.1 mol% and ≤ 0.5 mol%, of polymeric units derived from a functionalized olefin monomer;
based on the total moles of all polymeric units constituting the ethylene terpolymer; and
**d.** a polymer mixture comprising any combination of polymers (a) to (c);
wherein the functionalized olefin monomer is a monomer selected from:
i. a hydroxyl group containing olefin monomer having 4 to 12 carbon atoms, preferably 4 to 8 carbon atoms;
ii. a carboxylic acid containing olefin monomer having 2 to 12 carbon atoms, preferably 4 to 8 carbon atoms; and
iii. an esterified olefin monomer represented by the formula: 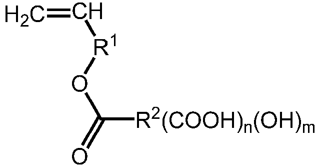
• wherein R¹ is selected from a hydrocarbyl group having 2 to 10 carbon atoms, preferably 2 to 6 carbon atoms, more preferably 4 or 6 carbon atoms;
• wherein R² is selected from a hydrocarbyl group having 2 to 10 carbon atoms, and
• wherein 'n' is an integer from 1 to 3 and 'm' is an integer from 0 to 4, preferably 1 to 4.
wherein the functionalized polyolefin polymer comprises ≤ 0.8 wt%, preferably ≤ 0.5 wt%, preferably ≤ 0.2 wt%, of metal, based on the total weight of the functionalized polyolefin polymer and determined using Inductively Coupled Plasma Mass Spectrometry, preferably the inorganic metal oxide comprises a metal selected from Group 13 (Group III) of the Periodic Table, preferably the inorganic metal oxide is alumina or its hydrated analogues, aluminum hydroxide oxide or aluminum hydroxide.

2. The film according to claim 1,wherein the functionalized polyolefin is present in an amount of ≥ 25.0 wt% and 100 wt%, preferably ≥ 25.0 wt% and ≤ 95.0 wt%, preferably ≥ 30.0 wt% and ≤ 80.0 wt%, preferably ≥ 35.0 wt% and ≤ 75.0 wt%, preferably ≥ 40.0 wt% and ≤ 70.0 wt%, preferably ≥ 45 wt% and ≤ 55wt%, preferably 50 wt%, based on the total weight of the blend.

3. The film according to claim 1 or 2, wherein (i) the carboxylic acid containing olefin monomer is selected from the group consisting of acrylic acid, 3-butenoic acid, 4-pentenoic acid, 5-hexenoic acid, 10-undecenoic acid, 5-norbornene-2-carboxylic acid and 5-norbornene-2-acetic acid, preferably the carboxylic acid containing olefin monomer is acrylic acid, 3-butenoic acid, 4-pentenoic acid and 5-norbornene-2-carboxylic acid; and/or wherein (ii) the hydroxyl group containing olefin monomer is selected from the group consisting of 3-buten-1-ol, 5-hexen-1-ol, 7-octen-1-ol, and 10-undecen-1-ol, preferably the hydroxyl group containing olefin monomer is 5-hexen-1-ol.

4. The film according to claim 1-3, wherein (i) the first olefin monomer comprising either 2 or 4 to 8 carbon atoms, is a monomer selected from the group consisting of ethylene, 1-butene, 1-hexene, 4-methyl-1-pentene, vinylcyclohexane, and 1-octene, preferably the first olefin monomer is selected from ethylene, or 1-hexene; and/or wherein (ii) the second olefin monomer comprising 3 to 8 carbon atoms is a monomer selected from the group consisting of propylene, 1-butene, 1-hexene, 4-methyl-1-pentene, vinylcyclohexane, and 1-octene, preferably the second olefin monomer is 1-octene.

5. The film according to any one of claims 1-4, wherein the functionalized polyolefin polymer is selected from poly(C₃-*co*-C₂-*co*-C₆OH), poly(C₃-*co*-C₄-*co*-C₆OH), poly(C₃-*co*-C₆-*co-*C₆OH), poly(C₃-*co*-C₈-*co*-C₆OH), poly(C₃-*co*-C₆OH), poly(C₃-*co*-C₂-*co*-C₆OX), poly(C₃-co-C₆-co-C₆OX), and combinations thereof, preferably the functionalized polyolefin polymer is selected from poly(C₃-*co*-C₂-*co*-C₆OH), poly(C₃-*co*-C₄-*co*-C₆OH), poly(C₃-*co-*C₆-*co*-C₆OH), poly(C₃-co-C₆-co-C₆OX) and combinations thereof, more preferably the functionalized polyolefin polymer is poly(C₃-*co*-C₆-*co*-C₆OH),
wherein C₂ represents ethylene monomer, C₃ represents propylene monomer, C₄ represents 1-butene monomer, C₆ represents 1-hexene monomer, C₈ represents 1-octene monomer and C₆OH represents 5-hexen-1-ol monomer, and 'X' represents a moiety derived from citric acid, citric acid anhydride, gluconic acid, glucaric acid, isocitric acid, tartaric acid, succinic acid, succinic acid anhydride, fumaric acid, malic acid, maleic acid anhydride, itaconoic acid, itaconoic acid anhydride, oxalic acid, trimesic acid, 1,2,4-benzenetricarboxylix-1,2-anhydride, propan-1,2-3-tricarboxylic acid, 2-phosphonobutane-1,2,4-tricarboxylic acid (PBTC), preferably 'X' is a moiety derived from citric acid.

6. The film according to any of the claims 1-5, wherein the functionalized polyolefin polymer has:
i) A metal content of ≥ 0.0 wt% and ≤ 0.8 wt%, preferably ≥ 0.0 wt% and ≤ 0.3 wt%, preferably ≥ 0.0 wt% and ≤ 0.2 wt%, preferably ≥ 0.01 wt% and ≤ 0.2 wt%, preferably ≥ 0.1 wt% and ≤ 0.2 wt%, based on the total weight of the functionalized polyolefin copolymer and determined using Inductively Coupled Plasma Mass Spectrometry; and/or
ii) a peak melting temperature (*T*ₘ) of ≥ 50.0 °C and ≤ 120.0 °C, preferably ≥ 70.0 °C and ≤ 100.0 °C, preferably ≥ 75.0 °C and ≤ 95.0 °C, preferably ≥ 75.0 °C and ≤ 90.0 °C as determined using differential scanning calorimetry (DSC) in accordance with ASTM D3418 (2008).

7. The film according to any of the claims 1-6, wherein the functionalized polyolefin polymer has:
i) a hydroxyl functional group content of ≥ 0.1 and ≤ 1.0 mol%, preferably ≥ 0.2 and ≤ 0.8 mol%, preferably ≥ 0.2 and ≤ 0.6 mol%, when determined using NMR spectroscopy; and/or
ii) a Polydispersity Index (PDI) of ≥ 1.5 and ≤ 6.0, preferably ≥ 2.0 and ≤ 6.0, preferably ≥ 4.0 and ≤ 6.0, wherein PDI is calculated by dividing the weight average molecular weight (*M*_{w}) by the number average molecular weight (*M*ₙ) and wherein each of *M*_{w} and *M*ₙ are determined in accordance with ASTM D6474-12.

8. The film according to any of the claims 1-7, wherein the functionalized polyolefin polymer has:
i) a weight average molecular weight (*M*_{w}) ≥ 75.0 kg/mol and ≤ 300.0 kg/mol, preferably ≥ 100.0 kg/mol and ≤ 150.0 kg/mol and determined in accordance with ASTM D6474-12; and/or
ii) a crystallization temperature (*T_{c}*) of ≥ 20 °C and ≤ 80 °C, preferably ≥ 40 °C and ≤ 60 °C, preferably ≥ 35 °C and ≤ 55 °C, preferably ≥ 35 °C and ≤ 50 °C as determined using differential scanning calorimetry (DSC) in accordance with ASTM D3418 (2008); and/or
iii) a glass transition temperature (*T*_{g}) of ≥ -50.0 °C and ≤ 5.0 °C, preferably ≥ -10.0 °C and ≤ 2.0 °C, preferably ≥ -5.0 °C and ≤ 2.0 °C, preferably ≥ -2.0 °C and ≤ - 1.0 °C as determined using dynamic mechanical thermal analysis (DMTA) in accordance with ISO 6721-10:2015.

9. The film according to any of the claims 1-8, wherein the film exhibits:
a. a volume resistivity of ≥ 1.0 × 10¹³ and ≤ 3.0 × 10¹⁶, preferably ≥ 1.0 × 10¹⁴ and ≤ 2.5 × 10¹⁵, preferably ≥ 1.0 × 10¹⁴ and ≤ 2.0 × 10¹⁴ when determined in accordance with ASTM D257-14 (2021) at an applied voltage of 1000V for a time period of 600 seconds and at a temperature of 25 °C; and/or
b. an optical transmittance of ≥ 30.0 % and ≤ 95.0 %, preferably ≥ 40.0 % and ≤ 95.0 %, preferably ≥ 44.0 % and ≤ 85.0 %, preferably ≥ 45.0 % and ≤ 60.0 %, preferably ≥ 45.0 % and ≤ 50.0 %, when determined in accordance with ASTM D1003 (2021).

10. The film according to any of the claims 1-9, wherein the film exhibits:
a. a tensile strength at break of ≥ 15.0 MPa and ≤ 60.0 MPa, preferably ≥ 15.0 MPa and ≤ 60.0 MPa, preferably ≥ 20.0 MPa and < 40.0 MPa, preferably ≥ 22.0 MPa and ≤ 30.0 MPa, when determined in accordance with ASTM D882 (2018); and/or
**b.** a tensile modulus of ≥ 30.0 MPa and ≤ 130.0 MPa, preferably ≥ 30.0 MPa and ≤ 100.0 MPa, preferably ≥ 30.0 MPa and ≤ 80.0 MPa, preferably ≥ 30.0 MPa and ≤ 60.0 MPa, preferably ≥ 35.0 MPa and ≤ 55.0 MPa, preferably ≥ 40.0 MPa and ≤ 50.0 MPa, when determined in accordance with ASTM D882 (2018).

11. The film according to any of the claims 1-10, wherein the non-functionalized polyolefin is polyethylene, poly(ethylene-co-propylene), poly(ethylene-co-1-butene), poly(ethylene-co-1-hexene), poly(ethylene-co-1-octene), polypropylene, poly(propylene-co-ethylene), poly(propylene-co-1-butene), poly(propylene-co-1-hexene), poly(propylene-co-1-octene).

12. A process for preparing the film according to any one of the claims 1-11, wherein the process comprises at least one step involving any one of film extrusion and casting, or compression molding, preferably the process for preparing the film comprises a step of film extrusion and casting comprising the steps of:
a. providing the functionalized polyolefin polymer according to any one of claims 1-11;
b. extruding the functionalized polyolefin polymer at a melt temperature of ≤ 225 °C and forming and extrudate; and
c. cooling the extrudate and forming the film.

13. An encapsulated solar cell comprising a solar cell positioned between a first encapsulant layer and a second encapsulant layer, wherein at least one of the first encapsulant layer or the second encapsulant layer, preferably each of the first encapsulant layer and the second encapsulant layer, comprises or consists of the film according to any one of claims 1-11, further wherein the solar cell is positioned such that the first encapsulant layer and the second encapsulant layer are joined so as to at least partially encapsulate the solar cell.

14. A photovoltaic module comprising the encapsulated solar cell according to claim 13, preferably wherein the photovoltaic module comprises:
a. a front layer;
b. a back layer; and
c. the encapsulated solar cell, wherein the encapsulated solar cell is positioned between the front layer and the back layer preferably such that the front layer is in direct contact with the first encapsulant layer and the second encapsulant layer is in direct contact with the back layer.

15. The photovoltaic module of claim 14, wherein the front layer and/or the back layer comprises a material selected from the group consisting of a polypropylene composition, glass, polycarbonate composition, and any combinations thereof, preferably the front layer and/or the back layer comprise(s) a polypropylene composition.

16. A process for making the photovoltaic module of claims 14-15, wherein the process comprises the step of:
a) assembling the front layer, the first encapsulant layer, the solar cell, the second encapsulant layer and the back layer to form a photovoltaic assembly such that the solar cell is positioned between the first encapsulant layer and the second encapsulant layer, preferably such that the front layer is in direct contact with the first encapsulant layer; and the second encapsulant layer is in direct contact with the back layer;
b) heating the photovoltaic assembly at a temperature such that at least a portion of the first encapsulant layer and the second encapsulant layer melt to form a melted photovoltaic assembly comprising the solar cell;
c) pressing the melted photovoltaic assembly under heated conditions and forming the laminated photovoltaic module; and
d) cooling the laminated photovoltaic module to ambient temperature and obtaining the photovoltaic module.

17. Use of the film of claims 1-11, as an encapsulant film for a photovoltaic module.

## Patentansprüche

1. Folie, umfassend ein Gemisch aus nicht funktionalisiertem Polyolefin und funktionalisiertem Polyolefinpolymer,
wobei das nicht funktionalisierte Polyolefin ein Polymer ist, das aus der Gruppe ausgewählt ist bestehend aus Polyolefin-Thermoplast, Polyolefin-Plastomer und Polyolefin-Elastomer, und
wobei das funktionalisierte Polyolefinpolymer ein Polymer ist, das aus der Gruppe ausgewählt ist bestehend aus:
a) einem Propylencopolymer, umfassend
i. ≥ 95,0 Mol-% und ≤ 99,95 Mol-%, vorzugsweise ≥ 98,0 Mol-% und ≤ 99,95 Mol-%, vorzugsweise ≥ 99,0 Mol-% und ≤ 99,9 Mol-%, vorzugsweise ≥ 99,5 Mol-% und ≤ 99,9 Mol-% an Polymereinheiten, die von Propylen abgeleitet sind, und
ii. ≥ 0,05 Mol-% und ≤ 5,0 Mol-%, vorzugsweise ≥ 0,05 Mol-% und ≤ 2,0 Mol-%, vorzugsweise ≥ 0,1 Mol-% und ≤ 1,0 Mol-%, vorzugsweise ≥ 0,1 Mol-% und ≤ 0,5 Mol-% an Polymereinheiten, die von einem funktionalisierten Olefinmonomer abgeleitet sind,
bezogen auf die Gesamtmolzahl aller Polymereinheiten, die das Propylencopolymer bilden;
b) einem Propylenterpolymer, umfassend
i. ≥ 80,0 Mol-% und ≤ 98,95 Mol-%, vorzugsweise ≥ 88,0 Mol-% und ≤ 98,0 Mol-%, vorzugsweise ≥ 90,0 Mol-% und ≤ 96,0 Mol-% an Polymereinheiten, die von Propylen abgeleitet sind;
ii. ≥ 0,1 Mol-% und ≤ 19,95 Mol-%, vorzugsweise ≥ 1,0 Mol-% und ≤ 10,0 Mol-%, vorzugsweise ≥ 3,5 Mol-% und ≤ 9,9 Mol-% an Polymereinheiten, die von einem ersten Olefinmonomer abgeleitet sind, das entweder 2 oder 4 bis 8 Kohlenstoffatome umfasst, wobei das erste Olefinmonomer vorzugsweise 2 oder 6 Kohlenstoffatome umfasst; und
iii. ≥ 0,05 Mol-% und ≤ 5,0 Mol-%, vorzugsweise ≥ 0,1 Mol-% und ≤ 2,0 Mol-%, vorzugsweise ≥ 0,1 Mol-% und ≤ 0,5 Mol-% an Polymereinheiten, die von einem funktionalisierten Olefinmonomer abgeleitet sind,
bezogen auf die Gesamtmolzahl aller Polymereinheiten, die das Propylenterpolymer bilden;
c) einem Ethylenterpolymer, umfassend:
i. ≥ 80,0 Mol-% und ≤ 98,95 Mol-%, vorzugsweise ≥ 90,0 Mol-% und ≤ 97,0 Mol-% an Polymereinheiten, die von Ethylen abgeleitet sind,
ii. ≥ 0,1 Mol-% und ≤ 19,95 Mol-%, vorzugsweise ≥ 2,5 Mol-% und ≤ 9,9 Mol-% an Polymereinheiten, die von einem zweiten Olefinmonomer abgeleitet sind, das 3 bis 8 Kohlenstoffatome umfasst, wobei das zweite Olefinmonomer vorzugsweise 8 Kohlenstoffatome umfasst; und
iii. ≥ 0,05 Mol-% und ≤ 5,0 Mol-%, vorzugsweise ≥ 0,1 Mol-% und ≤ 0,5 Mol-% an Polymereinheiten, die von einem funktionalisierten Olefinmonomer abgeleitet sind;
bezogen auf die Gesamtmolzahl aller Polymereinheiten, die das Ethylenterpolymer bilden; und
d) einer Polymermischung, umfassend eine beliebige Kombination von Polymeren (a) bis (c);
wobei das funktionalisierte Olefinmonomer ein Monomer ist, das ausgewählt ist aus:
i. einem hydroxylgruppenhaltigen Olefinmonomer mit 4 bis 12 Kohlenstoffatomen, vorzugsweise 4 bis 8 Kohlenstoffatomen;
ii. einem carbonsäurehaltigen Olefinmonomer mit 2 bis 12 Kohlenstoffatomen, vorzugsweise 4 bis 8 Kohlenstoffatomen; und
iii. einem veresterten Olefinmonomer, dargestellt durch die Formel: 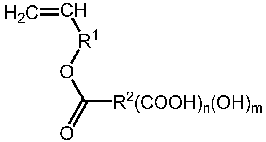
- wobei R¹ ausgewählt ist aus einer Hydrocarbylgruppe mit 2 bis 10 Kohlenstoffatomen, vorzugsweise 2 bis 6 Kohlenstoffatomen, bevorzugter 4 oder 6 Kohlenstoffatomen;
- wobei R² ausgewählt ist aus einer Hydrocarbylgruppe mit 2 bis 10 Kohlenstoffatomen, und
- wobei 'n' eine ganze Zahl von 1 bis 3 ist und 'm' eine ganze Zahl von 0 bis 4, vorzugsweise 1 bis 4 ist.
wobei das funktionalisierte Polyolefinpolymer ≤ 0,8 Gew.-%, vorzugsweise ≤ 0,5 Gew.-%, vorzugsweise ≤ 0,2 Gew.-% an Metall umfasst, bezogen auf das Gesamtgewicht des funktionalisierten Polyolefinpolymers und bestimmt unter Verwendung von Massenspektrometrie mit induktiv gekoppeltem Plasma, wobei das anorganische Metalloxid vorzugsweise ein Metall umfasst, das aus der Gruppe 13 (Gruppe III) des Periodensystems ausgewählt ist, wobei das anorganische Metalloxid vorzugsweise Aluminiumoxid oder seine hydratisierten Analoga, Aluminiumhydroxidoxid oder Aluminiumhydroxid ist.

2. Folie nach Anspruch 1, wobei das funktionalisierte Polyolefin in einer Menge von ≥ 25,0 Gew.-% und 100 Gew.-%, vorzugsweise ≥ 25,0 Gew.-% und ≤ 95,0 Gew.-%, vorzugsweise ≥ 30,0 Gew.-% und ≤ 80,0 Gew.-%, vorzugsweise ≥ 35,0 Gew.-% und ≤ 75,0 Gew.-%, vorzugsweise ≥ 40,0 Gew.-% und ≤ 70,0 Gew.-%, vorzugsweise ≥ 45 Gew.-% und ≤ 55 Gew.-%, vorzugsweise 50 Gew.-% vorhanden ist, bezogen auf das Gesamtgewicht des Gemischs.

3. Folie nach Anspruch 1 oder 2, wobei (i) das carbonsäurehaltige Olefinmonomer aus der Gruppe ausgewählt ist bestehend aus Acrylsäure, 3-Butensäure, 4-Pentensäure, 5-Hexensäure, 10-Undecensäure, 5 -Norbornen-2-carbonsäure und 5-Norbornen-2-essigsäure, wobei das carbonsäurehaltige Olefinmonomer vorzugsweise Acrylsäure, 3-Butensäure, 4-Pentensäure und 5-Norbornen-2-carbonsäure ist; und/oder wobei (ii) das hydroxylgruppenhaltige Olefinmonomer aus der Gruppe ausgewählt ist bestehend aus 3-Buten-1-ol, 5-Hexen-1-ol, 7-Octen-1-ol und 10-Undecen-1-ol, wobei das hydroxylgruppenhaltige Olefinmonomer vorzugsweise 5-Hexen-1-ol ist.

4. Folie nach Anspruch 1-3, wobei (i) das erste Olefinmonomer, das entweder 2 oder 4 bis 8 Kohlenstoffatome umfasst, ein Monomer ist, das aus der Gruppe ausgewählt ist bestehend aus Ethylen, 1-Buten, 1-Hexen, 4-Methyl-1-penten, Vinylcyclohexan und 1-Octen, wobei das erste Olefinmonomer vorzugsweise ausgewählt ist aus Ethylen oder 1-Hexen; und/oder wobei (ii) das zweite Olefinmonomer, das 3 bis 8 Kohlenstoffatome umfasst, ein Monomer ist, das aus der Gruppe ausgewählt ist bestehend aus Propylen, 1-Buten, 1-Hexen, 4-Methyl-1-penten, Vinylcyclohexan und 1-Octen, wobei das zweite Olefinmonomer vorzugsweise 1-Octen ist.

5. Folie nach einem der Ansprüche 1-4, wobei das funktionalisierte Polyolefinpolymer ausgewählt ist aus Poly(C₃-*co*-C₂-*co*-C₆OH), Poly(C₃-*co*-C₄-*co*-C₆OH), Poly(C₃-*co*-C₆-*co-*C₆OH), Poly(C₃-*co*-C₈-*co*-C₆OH), Poly(C₃-*co*-C₆OH), Poly(C₃-*co*-C₂-*co*-C₆OX), Poly(C₃-*co*-C₆-co-C₆OX) und Kombinationen davon, wobei das funktionalisierte Polyolefinpolymer vorzugsweise ausgewählt ist aus Poly(C₃-*co*-C₂-*co*-C₆OH), Poly(C₃-*co*-C₄-*co*-C₆OH), Poly(C₃-*co*-C₆-*co*-C₆OH), Poly(C₃-co-C₆-co-C₆OX) und Kombinationen davon, wobei das funktionalisierte Polyolefinpolymer bevorzugter Poly(C₃-*co*-C₆-*co*-C₆OH) ist,
wobei C₂ Ethylenmonomer darstellt, C₃ Propylenmonomer darstellt, C₄ 1-Butenmonomer darstellt, C₆ 1-Hexenmonomer darstellt, C₈ 1-Octenmonomer darstellt und C₆OH 5-Hexen-1-ol-Monomer darstellt, und 'X' für eine Gruppierung steht, die von Zitronensäure, Zitronensäureanhydrid, Gluconsäure, Glucarsäure, Isocitronensäure, Weinsäure, Bernsteinsäure, Bernsteinsäureanhydrid, Fumarsäure, Apfelsäure, Maleinsäureanhydrid, Itaconsäure, Itaconsäureanhydrid, Oxalsäure, Trimesinsäure, 1,2,4-Benzoltricarboxylix-1,2-anhydrid, Propan-1,2-3-tricarbonsäure, 2-Phosphonobutan-1,2,4-tricarbonsäure (PBTC) abgeleitet ist, wobei 'X' vorzugsweise eine von Zitronensäure abgeleitete Gruppierung ist.

6. Folie nach einem der Ansprüche 1-5, wobei das funktionalisierte Polyolefinpolymer aufweist:
i) einen Metallgehalt von ≥ 0,0 Gew.-% und ≤ 0,8 Gew.-%, vorzugsweise ≥ 0,0 Gew.-% und ≤ 0,3 Gew.-%, vorzugsweise ≥ 0,0 Gew.-% und ≤ 0,2 Gew.-%, vorzugsweise ≥ 0,01 Gew.-% und ≤ 0,2 Gew.-%, vorzugsweise ≥ 0,1 Gew.-% und ≤ 0,2 Gew.-%, bezogen auf das Gesamtgewicht des funktionalisierten Polyolefincopolymers und bestimmt unter Verwendung von Massenspektrometrie mit induktiv gekoppeltem Plasma; und/oder
ii) eine Spitzenschmelztemperatur (Tm) von ≥ 50,0 °C und ≤ 120,0 °C, vorzugsweise ≥ 70,0 °C und ≤ 100,0 °C, vorzugsweise ≥ 75,0 °C und ≤ 95,0 °C, vorzugsweise ≥ 75,0 °C und ≤ 90,0 °C, wie unter Verwendung von dynamischer Differenzkalorimetrie (DSC) nach ASTM D3418 (2008) bestimmt.

7. Folie nach einem der Ansprüche 1-6, wobei das funktionalisierte Polyolefinpolymer aufweist:
i) einen Gehalt an funktionellen Hydroxylgruppen von ≥ 0,1 und ≤ 1,0 Mol-%, vorzugsweise ≥ 0,2 und ≤ 0,8 Mol-%, vorzugsweise ≥ 0,2 und ≤ 0,6 Mol-%, wenn unter Verwendung von NMR-Spektroskopie bestimmt; und/oder
ii) einen Polydispersitätsindex (PDI) von ≥ 1,5 und ≤ 6,0, vorzugsweise ≥ 2,0 und ≤ 6,0, vorzugsweise ≥ 4,0 und ≤ 6,0, wobei PDI durch Dividieren des gewichtsmittleren Molekulargewichts (*M*_{w}) durch die Zahl des durchschnittlichen Molekulargewichts (*M*ₙ) berechnet wird und wobei jedes von *M*_{w} und *M*ₙ nach ASTM D6474-12 bestimmt wird.

8. Folie nach einem der Ansprüche 1-7, wobei das funktionalisierte Polyolefinpolymer aufweist:
i) ein gewichtsmittleres Molekulargewicht (*M*_{w}) ≥ 75,0 kg/mol und ≤ 300,0 kg/mol, vorzugsweise ≥ 100,0 kg/mol und ≤ 150,0 kg/mol und bestimmt nach ASTM D6474-12; und/oder
ii) eine Kristallisationstemperatur (*T_{c}*) von ≥ 20 °C und ≤ 80 °C, vorzugsweise ≥ 40 °C und ≤ 60 °C, vorzugsweise ≥ 35 °C und ≤ 55 °C, vorzugsweise ≥ 35 °C und ≤ 50 °C, wie unter Verwendung von dynamischer Differenzkalorimetrie (DSC) nach ASTM D3418 (2008) bestimmt; und/oder
iii) eine Glasübergangstemperatur (*T_{g}*) von ≥ -50,0 °C und ≤ 5,0 °C, vorzugsweise ≥ -10,0 °C und ≤ 2,0 °C, vorzugsweise ≥ -5,0 °C und ≤ 2,0 °C, vorzugsweise ≥ -2,0 °C und ≤ - 1,0 °C, wie unter Verwendung von dynamischer mechanisch-thermischer Analyse (DMTA) nach ISO 6721-10:2015 bestimmt.

9. Folie nach einem der Ansprüche 1-8, wobei die Folie vorweist:
a) einen Volumenwiderstand von ≥ 1,0 x 10¹³ und ≤ 3,0 x 10¹⁶, vorzugsweise ≥ 1,0 x 10¹⁴ und ≤ 2,5 x 10¹⁵, vorzugsweise ≥ 1,0 x 10¹⁴ und ≤ 2,0 x 10¹⁴, wenn nach ASTM D257-14 (2021) bei einer angelegten Spannung von 1000 V für einen Zeitraum von 600 Sekunden und bei einer Temperatur von 25 °C bestimmt; und/oder
b) eine optische Durchlässigkeit von ≥ 30,0 % und ≤ 95,0 %, vorzugsweise ≥ 40,0 % und ≤ 95,0 %, vorzugsweise ≥ 44,0 % und ≤ 85,0 %, vorzugsweise ≥ 45,0 % und ≤ 60,0 %, vorzugsweise ≥ 45,0 % und ≤ 50,0 %, wenn nach ASTM D1003 (2021) bestimmt.

10. Folie nach einem der Ansprüche 1-9, wobei die Folie vorweist:
a) eine Zugfestigkeit bei Bruch von ≥ 15,0 MPa und ≤ 60,0 MPa, vorzugsweise ≥ 15,0 MPa und ≤ 60,0 MPa, vorzugsweise ≥ 20,0 MPa und ≤ 40,0 MPa, vorzugsweise ≥ 22,0 MPa und ≤ 30,0 MPa, wenn nach ASTM D882 (2018) bestimmt; und/oder
b) einen Zugmodul von ≥ 30,0 MPa und ≤ 130,0 MPa, vorzugsweise ≥ 30,0 MPa und ≤ 100,0 MPa, vorzugsweise ≥ 30,0 MPa und ≤ 80,0 MPa, vorzugsweise ≥ 30,0 MPa und ≤ 60,0 MPa, vorzugsweise ≥ 35,0 MPa und ≤ 55,0 MPa, vorzugsweise ≥ 40,0 MPa und ≤ 50,0 MPa, wenn nach ASTM D882 (2018) bestimmt.

11. Folie nach einem der Ansprüche 1-10, wobei das nicht funktionalisierte Polyolefin Polyethylen, Poly(ethylen-co-propylen), Poly(ethylen-co-1-buten), Poly(ethylen-co-1-hexen), Poly(ethylen-co-1-octen), Polypropylen, Poly(propylen-co-ethylen), Poly(propylen-co-1-buten), Poly(propylen-co-1-hexen), Poly(propylen-co-1-octen) ist.

12. Prozess zum Herstellen der Folie nach einem der Ansprüche 1-11, wobei der Prozess mindestens einen Schritt umfasst, der eines von Folienextrusion und Gießen oder Formpressen beinhaltet, wobei der Prozess zum Herstellen der Folie vorzugsweise einen Schritt von Folienextrusion und Gießen umfasst, umfassend die Schritte:
a) Bereitstellen des funktionalisierten Polyolefinpolymers nach einem der Ansprüche 1-11;
b) Extrudieren des funktionalisierten Polyolefinpolymers bei einer Schmelztemperatur von ≤ 225 °C und Bilden und Extrudieren; und
c) Kühlen des Extrudats und Bilden der Folie.

13. Eingekapselte Solarzelle, die eine Solarzelle umfasst, die zwischen einer ersten Einkapselungsschicht und einer zweiten Einkapselungsschicht positioniert ist, wobei mindestens eine der ersten Einkapselungsschicht oder der zweiten Einkapselungsschicht, vorzugsweise jede der ersten Einkapselungsschicht und der zweiten Einkapselungsschicht, die Folie nach einem der Ansprüche 1-11 umfasst oder daraus besteht, wobei die Solarzelle weiter derart positioniert ist, dass die erste Einkapselungsschicht und die zweite Einkapselungsschicht verbunden sind, um die Solarzelle mindestens teilweise einzukapseln.

14. Photovoltaikmodul, das die eingekapselte Solarzelle nach Anspruch 13 umfasst, wobei das Photovoltaikmodul vorzugsweise umfasst:
a) eine vordere Schicht;
b) eine hintere Schicht; und
c) die eingekapselte Solarzelle, wobei die eingekapselte Solarzelle zwischen der vorderen Schicht und der hinteren Schicht positioniert ist, vorzugsweise derart, dass die vordere Schicht in direktem Kontakt mit der ersten Einkapselungsschicht steht und die zweite Einkapselungsschicht in direktem Kontakt mit der hinteren Schicht steht.

15. Photovoltaikmodul nach Anspruch 14, wobei die vordere Schicht und/oder die hintere Schicht ein Material umfasst, das aus der Gruppe ausgewählt ist, die aus einer Polypropylenzusammensetzung, Glas, einer Polycarbonatzusammensetzung und beliebigen Kombinationen davon besteht, vorzugsweise die vordere Schicht und/oder die hintere Schicht eine Polypropylenzusammensetzung umfasst.

16. Prozess zur Herstellung des Photovoltaikmoduls nach den Ansprüchen 14-15, wobei der Prozess den folgenden Schritt umfasst:
a) Zusammenfügen der vorderen Schicht, der ersten Einkapselungsschicht, der Solarzelle, der zweiten Einkapselungsschicht und der hinteren Schicht, um eine Photovoltaikanordnung zu bilden, sodass die Solarzelle zwischen der ersten Einkapselungsschicht und der zweiten Einkapselungsschicht positioniert ist, vorzugsweise sodass die vordere Schicht in direktem Kontakt mit der ersten Einkapselungsschicht steht; und die zweite Einkapselungsschicht in direktem Kontakt mit der hinteren Schicht steht;
b) Erhitzen der Photovoltaikanordnung bei einer Temperatur, bei der mindestens ein Abschnitt der ersten Einkapselungsschicht und der zweiten Einkapselungsschicht schmelzen, um eine geschmolzene Photovoltaikanordnung zu bilden, die die Solarzelle umfasst;
c) Pressen der geschmolzenen Photovoltaikanordnung unter erwärmten Bedingungen und Bilden des laminierten Photovoltaikmoduls; und
d) Abkühlen des laminierten Photovoltaikmoduls auf Umgebungstemperatur und Erhalten des Photovoltaikmoduls.

17. Verwendung der Folie nach den Ansprüchen 1-11 als Einkapselungsfolie für ein Photovoltaikmodul.

## Revendications

1. Film comprenant un mélange de polyoléfine non fonctionnalisée et de polymère de polyoléfine fonctionnalisé,
dans lequel la polyoléfine non fonctionnalisée est un polymère choisi dans le groupe consistant en un thermoplaste de polyoléfine, un plastomère de polyoléfine et un élastomère de polyoléfine, et
dans lequel le polymère de polyoléfine fonctionnalisé est un polymère choisi dans le groupe consistant en :
a) un copolymère de propylène comprenant
i. ≥ 95,0 % en moles et ≤ 99,95 % en moles, de préférence ≥ 98,0 % en moles et ≤ 99,95 % en moles, de préférence ≥ 99,0 % en moles et ≤ 99,9 % en moles, de préférence ≥ 99,5 % en moles et ≤ 99,9 % en moles, d'unités polymères dérivées du propylène, et
ii. ≥ 0,05 % en moles et ≤ 5,0 % en moles, de préférence ≥ 0,05 % en moles et ≤ 2,0 % en moles, de préférence ≥ 0,1 % en moles et ≤ 1,0 % en moles, de préférence ≥ 0,1 % en moles et ≤ 0,5 % en moles, d'unités polymères dérivées d'un monomère oléfinique fonctionnalisé,
basé sur le nombre total de moles de toutes les unités polymères constituant le copolymère de propylène ;
b) un terpolymère de propylène comprenant
i. ≥ 80,0 % en moles et ≤ 98,95 % en moles, de préférence ≥ 88,0 % en moles et ≤ 98,0 % en moles, de préférence ≥ 90,0 % en moles et ≤ 96,0 % en moles, d'unités polymères dérivées du propylène ;
ii. ≥ 0,1 % en moles et ≤ 19,95 % en moles, de préférence ≥ 1,0 % en moles et ≤ 10,0 % en moles, de préférence ≥ 3,5 % en moles et ≤ 9,9 % en moles, d'unités polymères dérivées d'un premier monomère oléfinique comprenant soit 2, soit 4 à 8 atomes de carbone, de préférence le premier monomère oléfinique comprenant 2 ou 6 atomes de carbone ; et
iii. ≥ 0,05 % en moles et ≤ 5,0 % en moles, de préférence ≥ 0,1 % en moles et ≤ 2,0 % en moles, de préférence ≥ 0,1 % en moles et ≤ 0,5 % en moles, d'unités polymères dérivées d'un monomère oléfinique fonctionnalisé,
basé sur le nombre total de moles de toutes les unités polymères constituant le terpolymère de propylène ;
c) un terpolymère d'éthylène comprenant :
i. ≥ 80,0 % en moles et ≤ 98,95 % en moles, de préférence ≥ 90,0 % en moles et ≤ 97,0 % en moles, d'unités polymères dérivées de l'éthylène,
ii. ≥ 0,1 % en moles et ≤ 19,95 % en moles, de préférence ≥ 2,5 % en moles et ≤ 9,9 % en moles, d'unités polymères dérivées d'un second monomère oléfinique comprenant de 3 à 8 atomes de carbone, de préférence le second monomère oléfinique comprenant 8 atomes de carbone ; et
iii. ≥ 0,05 % en moles et ≤ 5,0 % en moles, de préférence ≥ 0,1 % en moles et ≤ 0,5 % en moles, d'unités polymères dérivées d'un monomère oléfinique fonctionnalisé ;
basé sur le nombre total de moles de toutes les unités polymères constituant le terpolymère d'éthylène ; et
d) un mélange de polymères comprenant toute combinaison de polymères (a) à (c) ;
dans lequel le monomère oléfinique fonctionnalisé est un monomère choisi parmi :
i. un monomère oléfinique contenant un groupe hydroxyle présentant 4 à 12 atomes de carbone, de préférence 4 à 8 atomes de carbone ;
ii. un monomère oléfinique contenant un acide carboxylique présentant de 2 à 12 atomes de carbone, de préférence de 4 à 8 atomes de carbone ; et
iii. un monomère oléfinique estérifié représenté par la formule : 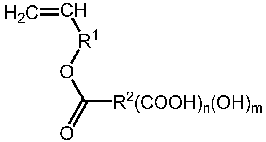
- dans laquelle R¹ est choisi parmi un groupe hydrocarbyle présentant 2 à 10 atomes de carbone, de préférence 2 à 6 atomes de carbone, plus préférentiellement 4 ou 6 atomes de carbone ;
- dans laquelle R² est choisi parmi un groupe hydrocarbyle présentant 2 à 10 atomes de carbone, et
- où « n » est un entier de 1 à 3 et « m » est un entier de 0 à 4, de préférence de 1 à 4,
dans lequel le polymère de polyoléfine fonctionnalisé comprend ≤ 0,8 % en poids, de préférence ≤ 0,5 % en poids, de préférence ≤ 0,2 % en poids, de métal, sur la base du poids total du polymère de polyoléfine fonctionnalisé et déterminé à l'aide d'une spectrométrie de masse à plasma à couplage inductif, de préférence l'oxyde métallique inorganique comprend un métal choisi dans le groupe 13 (groupe III) du tableau périodique, de préférence l'oxyde métallique inorganique est l'alumine ou ses analogues hydratés, l'oxyde d'hydroxyde d'aluminium ou l'hydroxyde d'aluminium.

2. Film selon la revendication 1, dans lequel la polyoléfine fonctionnalisée est présente en une quantité de ≥ 25,0 % en poids et 100 % en poids, de préférence ≥ 25,0 % en poids et ≤ 95,0 % en poids, de préférence ≥ 30,0 % en poids et ≤ 80,0 % en poids, de préférence ≥ 35,0 % en poids et ≤ 75,0 % en poids, de préférence ≥ 40,0 % en poids et ≤ 70,0 % en poids, de préférence ≥ 45 % en poids et ≤ 55 % en poids, de préférence 50 % en poids, sur la base du poids total du mélange.

3. Film selon la revendication 1 ou 2, dans lequel (i) le monomère oléfinique contenant un acide carboxylique est choisi dans le groupe consistant en l'acide acrylique, l'acide 3-buténoïque, l'acide 4-penténoïque, l'acide 5-hexénoïque, l'acide 10-undécénoïque, l'acide 5-norbornène-2-carboxylique et l'acide 5-norbornène-2-acétique, de préférence le monomère oléfinique contenant un acide carboxylique est l'acide acrylique, l'acide 3-buténoïque, l'acide 4-penténoïque et l'acide 5-norbornène-2-carboxylique ; et/ou dans lequel (ii) le monomère oléfinique contenant un groupe hydroxyle est choisi dans le groupe consistant en le 3-butén-1-ol, le 5-hexén-1-ol, le 7-octén-1-ol et le 10-undécén-1-ol, de préférence le monomère oléfinique contenant un groupe hydroxyle est le 5-hexén-1-ol.

4. Film selon les revendications 1-3, dans lequel (i) le premier monomère oléfinique comprenant 2 ou 4 à 8 atomes de carbone est un monomère choisi dans le groupe consistant en l'éthylène, le 1-butène, le 1-hexène, le 4-méthyl-1-pentène, le vinylcyclohexane et le 1-octène, de préférence le premier monomère oléfinique est choisi parmi l'éthylène ou le 1-hexène ; et/ou dans lequel (ii) le second monomère oléfinique comprenant 3 à 8 atomes de carbone est un monomère choisi dans le groupe consistant en le propylène, le 1-butène, le 1-hexène, le 4-méthyl-1-pentène, le vinylcyclohexane et le 1-octène, de préférence le second monomère oléfinique est le 1-octène.

5. Film selon l'une quelconque des revendications 1-4, dans lequel le polymère de polyoléfine fonctionnalisé est choisi parmi poly(C₃-*co*-C₂-*co*-C₆OH), poly(C₃-*co*-C₄-*co-*C₆OH), poly(C₃-*co-*C₆-*co*-C₆OH), poly(C₃-*co*-C₈-*co*-C₆OH), poly(C₃-*co*-C₆OH), poly(C₃-*co*-C₂-co-C₆OX), poly(C₃-co-C₆-co-C₆OX), et leurs combinaisons, de préférence le polymère de polyoléfine fonctionnalisé est choisi parmi poly(C₃-*co*-C₂-*co*-C₆OH), poly(C₃-*co*-C₄-*co-*C₆OH), poly(C₃-*co*-C₆-*co*-C₆OH), poly(C₃-co-C₆-co-C₆OX) et leurs combinaisons, plus préférentiellement le polymère de polyoléfine fonctionnalisé est le poly(C₃-*co*-C₆-*co-*C₆OH),
dans lequel C₂ représente un monomère d'éthylène, C₃ représente un monomère de propylène, C₄ représente un monomère de 1-butène, C₆ représente un monomère de 1-hexène, C₈ représente un monomère de 1-octène et C₆OH représente un monomère de 5-hexène-1-ol, et « X » représente un fragment dérivé de l'acide citrique, de l'anhydride d'acide citrique, de l'acide gluconique, de l'acide glucarique, de l'acide isocitrique, de l'acide tartrique, de l'acide succinique, de l'anhydride d'acide succinique, de l'acide fumarique, de l'acide malique, de l'anhydride d'acide maléique, de l'acide itaconoïque, de l'anhydride d'acide itaconoïque, de l'acide oxalique, de l'acide trimésique, du 1,2,4-benzènetricarboxylix-1,2-anhydride, de l'acide propan-1,2-3-tricarboxylique, de l'acide 2-phosphonobutane-1,2,4-tricarboxylique (PBTC), de préférence « X » est un fragment dérivé de l'acide citrique.

6. Film selon l'une quelconque des revendications 1-5, dans lequel le polymère de polyoléfine fonctionnalisé présente :
i) une teneur en métal ≥ 0,0 % en poids et ≤ 0,8 % en poids, de préférence ≥ 0,0 % en poids et ≤ 0,3 % en poids, de préférence ≥ 0,0 % en poids et ≤ 0,2 % en poids, de préférence ≥ 0,01 % en poids et ≤ 0,2 % en poids, de préférence ≥ 0,1 % en poids et ≤ 0,2 % en poids, sur la base du poids total du copolymère de polyoléfine fonctionnalisé et déterminée par spectrométrie de masse à plasma à couplage inductif ; et/ou
ii) une température de fusion maximale (Tm) de ≥ 50,0 °C et ≤ 120,0 °C, de préférence ≥ 70,0 °C et ≤ 100,0 °C, de préférence ≥ 75,0 °C et ≤ 95,0 °C, de préférence ≥ 75,0 °C et ≤ 90,0 °C telle que déterminée par calorimétrie différentielle à balayage (DSC) conformément à la norme ASTM D3418 (2008).

7. Film selon l'une quelconque des revendications 1-6, dans lequel le polymère de polyoléfine fonctionnalisé présente :
i) une teneur en groupes fonctionnels hydroxyle ≥ 0,1 et ≤ 1,0 % en moles, de préférence ≥ 0,2 et ≤ 0,8 % en moles, de préférence ≥ 0,2 et ≤ 0,6 % en moles, lorsqu'elle est déterminée par spectroscopie RMN ; et/ou
ii) un indice de polydispersité (PDI) ≥ 1,5 et ≤ 6,0, de préférence ≥ 2,0 et ≤ 6,0, de préférence ≥ 4,0 et ≤ 6,0, dans lequel le PDI est calculé en divisant le poids moléculaire moyen en poids (*M*_{w}) par le poids moléculaire moyen en nombre (*M*ₙ) et dans lequel chacun de *M*_{w} et de *M*ₙ est déterminé conformément à la norme ASTM D6474-12.

8. Film selon l'une quelconque des revendications 1-7, dans lequel le polymère de polyoléfine fonctionnalisé présente :
i) une masse moléculaire moyenne en poids (*M*_{w}) ≥ 75,0 kg/mol et ≤ 300,0 kg/mol, de préférence ≥ 100,0 kg/mol et ≤ 150,0 kg/mol et déterminée conformément à la norme ASTMD6474-12 ; et/ou
ii) une température de cristallisation (*T_{c}*) ≥ 20°C et ≤ 80°C, de préférence ≥ 40 °C et ≤ 60°C, de préférence ≥ 35 °C et ≤ 55 °C, de préférence ≥ 35 °C et ≤ 50°C telle que déterminée par calorimétrie différentielle à balayage (DSC) conformément à la norme ASTMD3418 (2008) ; et/ou
iii) une température de transition vitreuse (*T_{g}*) de ≥ -50,0 °C et ≤ 5,0°C, de préférence ≥ -10,0 °C et ≤ 2,0 °C, de préférence ≥ -5,0 °C et ≤ 2,0 °C, de préférence ≥ - 2,0°C et ≤ -1,0 °C telle que déterminée à l'aide d'une analyse thermique mécanique dynamique (DMTA) conformément à la norme ISO 6721-10:2015.

9. Film selon l'une quelconque des revendications 1-8, dans lequel le film présente :
a) une résistivité volumique ≥ 1,0 x 10¹³ et ≤ 3,0 x 10¹⁶, de préférence ≥ 1,0 x 10¹⁴ et ≤ 2,5 x 10¹⁵, de préférence ≥1,0 x 10¹⁴ et ≤ 2,0 x 10¹⁴ lorsqu'elle est déterminée conformément à la norme ASTM D257-14 (2021) à une tension appliquée de 1 000 V pendant une période de 600 secondes et à une température de 25 °C ; et/ou
b) une transmittance optique ≥ 30,0 % et ≤ 95,0 %, de préférence ≥ 40,0 % et ≤ 95,0 %, de préférence ≥ 44,0 % et ≤ 85,0 %, de préférence ≥ 45,0 % et ≤ 60,0 %, de préférence ≥ 45,0 % et ≤ 50,0 %, lorsqu'elle est déterminée conformément à la norme ASTM D1003 (2021).

10. Film selon l'une quelconque des revendications 1-9, dans lequel le film présente :
a) une résistance à la traction à la rupture ≥ 15,0 MPa et ≤ 60,0 MPa, de préférence ≥ 15,0 MPa et ≤ 60,0 MPa, de préférence ≥ 20,0 MPa et ≤ 40,0 MPa, de préférence ≥ 22,0 MPa et ≤ 30,0 MPa, lorsqu'elle est déterminée conformément à la norme ASTM D882 (2018) ; et/ou
b) un module de traction ≥ 30,0 MPa et ≤ 130,0 MPa, de préférence ≥ 30,0 MPa et ≤ 100,0 MPa, de préférence ≥ 30,0 MPa et ≤ 80,0 MPa, de préférence ≥ 30,0 MPa et ≤ 60,0 MPa, de préférence ≥ 35,0 MPa et ≤ 55,0 MPa, de préférence ≥ 40,0 MPa et ≤ 50,0 MPa, lorsqu'il est déterminé conformément à la norme ASTM D882 (2018).

11. Film selon l'une quelconque des revendications 1-10, dans lequel la polyoléfine non fonctionnalisée est le polyéthylène, le poly(éthylène-co-propylène), le poly(éthylène-co-1-butène), le poly(éthylène-co-1-hexène), le poly(éthylène-co-1-octène), le polypropylène, le poly(propylène-co-éthylène), le poly(propylène-co-1-butène), le poly(propylène-co-1-hexène), le poly(propylène-co-1-octène).

12. Processus de préparation du film selon l'une quelconque des revendications 1-11, dans lequel le processus comprend au moins une étape impliquant l'un quelconque parmi l'extrusion et le moulage du film, ou le moulage par compression, de préférence le processus de préparation du film comprend une étape d'extrusion et de moulage du film comprenant les étapes consistant à :
a) fournir le polymère de polyoléfine fonctionnalisé selon l'une quelconque des revendications 1-11 ;
b) extruder le polymère de polyoléfine fonctionnalisé à une température de fusion ≤ 225 °C et former un extrudat ; et
c) refroidir l'extrudat et former le film.

13. Cellule solaire encapsulée comprenant une cellule solaire positionnée entre une première couche encapsulante et une seconde couche encapsulante, dans laquelle au moins l'une de la première couche encapsulante ou de la seconde couche encapsulante, de préférence chacune de la première couche encapsulante et de la seconde couche encapsulante, comprend ou consiste en le film selon l'une quelconque des revendications 1-11, dans laquelle en outre la cellule solaire est positionnée de telle sorte que la première couche encapsulante et la seconde couche encapsulante sont jointes de manière à encapsuler au moins partiellement la cellule solaire.

14. Module photovoltaïque comprenant la cellule solaire encapsulée selon la revendication 13, de préférence dans lequel le module photovoltaïque comprend :
a) une couche avant ;
b) une couche arrière ; et
c) la cellule solaire encapsulée, dans lequel la cellule solaire encapsulée est positionnée entre la couche avant et la couche arrière de préférence de telle sorte que la couche avant est en contact direct avec la première couche encapsulante et la seconde couche encapsulante est en contact direct avec la couche arrière.

15. Module photovoltaïque selon la revendication 14, dans lequel la couche avant et/ou la couche arrière comprennent un matériau choisi dans le groupe consistant en une composition de polypropylène, du verre, une composition de polycarbonate et toutes combinaisons de ceux-ci, de préférence la couche avant et/ou la couche arrière comprennent une composition de polypropylène.

16. Processus de fabrication du module photovoltaïque selon les revendications 14-15, dans lequel le processus comprend les étapes consistant à :
a) assembler la couche avant, la première couche encapsulante, la cellule solaire, la seconde couche encapsulante et la couche arrière pour former un ensemble photovoltaïque de telle sorte que la cellule solaire soit positionnée entre la première couche encapsulante et la seconde couche encapsulante, de préférence de telle sorte que la couche avant soit en contact direct avec la première couche encapsulante ; et la seconde couche encapsulante soit en contact direct avec la couche arrière ;
b) chauffer l'ensemble photovoltaïque à une température telle qu'au moins une partie de la première couche encapsulante et de la seconde couche encapsulante fondent pour former un ensemble photovoltaïque fondu comprenant la cellule solaire ;
c) presser l'ensemble photovoltaïque fondu dans des conditions de chaleur et former le module photovoltaïque laminé ; et
d) refroidir le module photovoltaïque laminé à température ambiante et obtenir le module photovoltaïque.

17. Utilisation du film selon les revendications 1-11, comme film encapsulant pour un module photovoltaïque.
